# FASCICULE DE BREVET EUROPEEN

(11) **EP 1 378 003 B1**
(45) Date de publication et mention de la délivrance du brevet: **08.11.2017**
(21) Numéro de dépôt: 02732806.1
(22) Date de dépôt: 11.04.2002
(51) Int. Cl.: H01L 21/18, H01L 21/762, H01L 21/306, H01L 21/304, H01L 21/324, H01L 21/265, H01L 21/78, H01L 21/68

(54) **PROCEDE DE REALISATION D'UN SUBSTRAT OU STRUCTURE DEMONTABLE**
VERFAHREN ZUR HERSTELLUNG EINES ABSPALTBAREN SUBSTRATES ODER EINER ABSPALTBAREN STRUKTUR
METHOD FOR THE PRODUCTION OF A DETACHABLE SUBSTRATE OR DETACHABLE STRUCTURE

(30) Priorité: 13.04.2001 FR 0105129
(43) Date de publication de la demande: 07.01.2004
(73) Titulaire: Commissariat à l'Énergie Atomique et aux Énergies Alternatives, 75015 Paris (FR)
(72) Inventeur: ASPAR, Bernard, F-38100 Rives (FR); MORICEAU, Hubert, F-38120 Saint Egrève (FR); ZUSSY, Marc, F-38000 Grenoble (FR); RAYSSAC, Olivier, F-38000 Grenoble (FR)
(74) Mandataire: Colombo, Michel
(86) Numéro de dépôt international: PCT/FR2002/001266
(87) Numéro de publication internationale: WO 2002/084721

(56) Documents cités:
- EP-A- 0 938 129
- EP-A- 1 059 663
- WO-A1-01/04933
- FR-A- 2 771 852
- WIEGAND M ET AL: "Wafer bonding of silicon wafers covered with various surface layers" SENSORS AND ACTUATORS A, ELSEVIER SEQUOIA S.A., LAUSANNE, CH, vol. 86, no. 1-2, 30 octobre 2000 (2000-10-30), pages 91-95, XP004224534 ISSN: 0924-4247
- THEODORE N D ET AL: "TFSOI WITH IMPROVED OXIDATION RESISTANCE (TO REDUCE ISOLATION INDUCED STRESSES AND LEAKAGE)" MOTOROLA TECHNICAL DEVELOPMENTS, MOTOROLA INC. SCHAUMBURG, ILLINOIS, US, vol. 29, 1 novembre 1996 (1996-11-01), pages 158-159, XP000691920

## Description

### Domaine de l'invention

L'invention concerne la réalisation de composants à partir d'une couche mince sur un substrat, et la réalisation de cet ensemble couche mince-substrat. Ce substrat peut être initial ou intermédiaire, et être démontable, c'est à dire destiné à être séparé de cette couche mince.

### Etat de la technique

De plus en plus de composants doivent être intégrés sur des supports différents de ceux permettant leur réalisation.

Par exemple, on peut citer les composants sur substrats plastiques ou sur substrats souples. Par composants, on entend tout dispositif micro-électronique, optoélectronique ou capteur (par exemple chimique, mécanique, thermique, biologique ou biochimique) entièrement ou partiellement « processé », c'est à dire entièrement ou partiellement réalisé.

Pour intégrer ces composants sur des supports souples, on peut utiliser une méthode de report de couche.

Il existe de nombreux autres exemples d'applications où les techniques de report de couche peuvent fournir une solution adaptée pour l'intégration de composants ou de couches sur un support à priori inadapté à leur réalisation. Dans le même esprit, ces techniques de transfert de couches sont également très utiles lorsque l'on souhaite isoler une couche fine, avec ou sans composant, de son substrat initial, par exemple en procédant à une séparation ou élimination de ce dernier. Encore dans le même esprit, un retournement de couche fine associé à son transfert sur un autre support fournit aux ingénieurs un degré de liberté précieux pour pouvoir concevoir des structures impossibles par ailleurs. Ces prélèvements et retournements de films minces permettent par exemple de réaliser des structures dites enterrées telles que des capacités enterrées pour les DRAMs (Dynamic Random Access Memory) où, contrairement au cas usuel, les capacités sont d'abord formées puis reportées sur un autre substrat de silicium avant de reprendre la fabrication sur ce nouveau substrat du reste des circuits. Un autre exemple concerne la réalisation de structures de transistors dites à double grille. La première grille du transistor CMOS est réalisée selon une technologie conventionnelle sur un substrat puis reportée avec retournement sur un second substrat pour reprendre la réalisation de la deuxième grille et de la finition du transistor laissant ainsi la première grille enterrée dans la structure (voir par exemple K. Suzuki, T. Tanaka, Y. Tosaka, H. Horie and T Sugii, "High-Speed and Low Power n+-p+ Double-Gate SOI CMOS", IEICE Trans. Electron., vol. E78-C, 1995, pp. 360-367).

Vouloir isoler une couche mince de son substrat initial se rencontre par exemple dans le domaine des diodes électroluminescentes (LED en langage Anglo-saxon) comme il est par exemple reporté dans les documents W.S Wong et al., Journal of Electronic MATERIALS , page 1409, Vol. 28, N°12, 1999 ou 1. Pollentier et al., page 1056, SPIE Vol. 1361 Physical Concepts of Materials for Novel Optoelectronic Device Applications I (1990). Un des buts recherchés ici concerne un meilleur contrôle de l'extraction de la lumière émise. Un autre but concerne le fait que dans cet exemple particulier, le substrat sapphire ayant servi à réaliser l'empilement épitaxial, se retrouve à posteriori encombrant notamment du fait de son caractère électriquement isolant qui empêche tout prise de contact électrique en face arrière. Pouvoir se débarrasser de ce substrat sapphire dont l'emploi était avantageux pour la phase de croissance du matériau apparaît donc désormais souhaitable.

On retrouve une situation identique par exemple dans le domaine des applications liées aux télécommunications et hyperfréquence. Dans ce cas, on préfère que les composants soient intégrés en final sur un support présentant une résistivité élevée, typiquement de plusieurs kohms.cm au moins. Mais un substrat fortement résistif n'est pas forcément disponible aux mêmes coûts et qualité que les substrats standard habituellement utilisés. Dans le cas du silicium, on peut par exemple noter la disponibilité de plaques de silicium en diamètre 200 et 300mm de résistivité standard tandis que pour des résistivités supérieures à 1kohm.cm, l'offre est très inadaptée en 200mm et inexistante en 300mm. Une solution consiste à réaliser les composants sur substrats standards puis à reporter lors des étapes finales une couche fine contenant les composants sur un substrat isolant de type verre, Quartz, saphir, etc.

D'un point de vue technique, ces opérations de transfert ont pour intérêt majeur de décorréler les propriétés de la couche dans laquelle sont formés les composants et la couche support final, et trouvent par conséquent intérêt dans bien d'autres cas encore.

On peut encore citer les cas où le substrat d'intérêt pour la réalisation des composants coûte excessivement cher. Dans ce cas, celui du carbure de silicium par exemple offrant de meilleures performances (températures d'utilisation plus élevées, puissances et fréquences maximum d'utilisation significativement améliorées, ...) dont le coût comparativement au silicium est très élevé, on aurait intérêt à transférer une couche fine du substrat cher (le carbure de silicium ici) sur le substrat bon marché (le silicium ici), et à récupérer le résidu du substrat cher pour une réutilisation après éventuellement une opération de recyclage. L'opération de transfert peut avoir lieu avant, au cours ou après la réalisation des composants

Ces techniques peuvent également trouver leur intérêt dans tous les domaines où obtenir un substrat mince est important pour l'application finale. En particulier, on peut citer les applications de puissance, que ce soit pour des raisons liées à l'évacuation de chaleur qui sera d'autant meilleure que le substrat est fin, ou parce que certaines fois le courant doit traverser l'épaisseur des substrats avec des pertes en première approximation proportionnelles à l'épaisseur traversée par le courant. On peut aussi citer les applications de carte à puce pour lesquelles une finesse des substrats est recherchée pour des raisons de souplesse. Pour ces applications, la réalisation de circuits est faite sur des substrats épais ou d'épaisseur standard avec avantage d'une part de bien supporter mécaniquement les différentes étapes technologiques et d'autre part de répondre aux normes quant à leur passage sur certains équipements de production. L'amincissement est réalisé en final par séparation. Cette séparation peut s'accompagner d'un report sur un autre support. Dans certains cas, notamment lorsque l'épaisseur finale considérée lors de l'amincissement est suffisante pour obtenir des structures autoportées, le report sur un autre support n'est pas indispensable.

Différentes techniques peuvent être utilisées pour reporter des couches d'un support vers un autre support. On peut citer par exemple les techniques publiées en 1985 par T. Hamaguchi et al.- Proc. IEDM 1985 p. 688. Ces techniques présentent un grand intérêt puisqu'elles permettent effectivement de transférer une couche d'un substrat vers un autre substrat ; mais elles nécessitent la consommation du substrat de base (détruit au cours du procédé), et ne permettent pas le transfert homogène d'un film mince sauf si une couche d'arrêt (c'est à dire une couche formant une inhomogénéité dans la matière du substrat) est présente.

Parmi les procédés connus de report, il est également possible d'utiliser des méthodes de transfert de couches minces de matériaux contenant (ou pas) tout ou partie d'un composant microélectronique. Ces méthodes sont basées pour certaines sur la création dans un matériau d'une couche fragile enterrée, à partir de l'introduction d'une ou plusieurs espèces gazeuses. On peut à ce propos se référer aux documents US-A-5374564 (ou EP-A-533551), US-A-6020252 (ou EP-A-807970), FR-A-2767416 (ou EP-A-1010198) FR-A-2748850 (ou EP-A-902843) ou FR-A-2773261 (ou EP-A-963598), qui présentent ces procédés.

Ces procédés sont généralement utilisés avec l'objectif de détacher l'ensemble d'un film d'un substrat initial pour le reporter sur un support. Le film mince obtenu peut contenir alors une partie du substrat initial. Ces films peuvent servir de couches actives pour la réalisation de composants électroniques ou optiques. Ces films peuvent contenir tout ou partie d'un composant.

Ces méthodes permettent en particulier la réutilisation du substrat après séparation, ces substrats ne se consommant que très peu ainsi à chaque cycle. En effet, l'épaisseur prélevée n'est fréquemment que de quelques µms tandis que les épaisseur de substrat sont typiquement de plusieurs centaines de µms. On peut ainsi obtenir, en particulier dans le cas du procédé divulgué dans le document US-A-6020252 (ou EP-A-807970), des substrats qui sont assimilables à des substrats « démontables » (c'est à dire des substrats détachables) à l'aide d'une contrainte mécanique. Ce procédé particulier repose sur la formation par implantation d'une zone enterrée fragilisée selon laquelle se réalisera la découpe lors du transfert final.

D'autres méthodes, basées sur le principe du " lift-off " , permettent également de séparer une couche mince du reste de son support initial, toujours sans forcément consommer ce dernier. Ces méthodes utilisent généralement des attaques chimiques attaquant sélectivement une couche intermédiaire enterré, associées ou non à des efforts mécaniques. Ce type de méthode est très utilisé pour le report d'éléments III-V sur différents types de supports (Voir : C. Camperi et al. - IEEE Transaction and photonics technology - vol 3, 12 (1991) 1123). Comme il est expliqué dans l'article de P. Demeester et al., Semicond. Sci. Tcehnol. 8 (1993) 1124-1135, le report, ayant lieu généralement après une étape d'épitaxie, peut être réalisé avant ou après la réalisation des composants ("post-processing" ou "pre-processing" respectivement selon leur dénomination Anglo-saxonne).

Parmi les méthodes utilisant la présence d'une couche enterrée (préexistante) de tenue mécanique plus faible que le reste du substrat pour obtenir une séparation localisée, on peut citer le procédé ELTRAN® (Japanese Patent Publication Number 07302889). Dans ce cas un empilement à base de silicium monocristallin est fragilisé localement grâce à la formation d'une zone poreuse. Un autre cas similaire consiste à tirer profit de la présence d'un oxyde enterré dans le cas d'une structure SOI (Silicon On Insulator) aussi standard soit-elle (c'est à dire réalisée sans rechercher un effet démontable particulier). Si cette structure est collée de manière suffisamment forte sur un autre substrat et si on exerce une contrainte importante sur la structure, on peut obtenir une fracture localisée préférentiellement dans l'oxyde, menant à une découpe à l'échelle du substrat entier. Le document « PHILIPS Journal of Research vol. 49 N°1/2 1995 » en montre un exemple en pages 53 à 55. Malheureusement, cette fracture est difficilement contrôlable et elle nécessite des contraintes mécaniques importantes pour mener à la fracture, ce qui n'est pas sans risque de casse des substrats ou de détérioration concernant les composants.

L'avantage de tels procédés à couche fragile enterrée est de pouvoir réaliser des couches à base de silicium cristallin (ou de SiC, InP, AsGa LiNbO3, LiTaO3...) dans une gamme d'épaisseur pouvant aller de quelques dizaines d'angström (Å) à quelques micromètres (µm), avec une très bonne homogénéité. Des épaisseurs plus élevées restent également accessibles.

Pour fabriquer des structures démontables pour un éventuel report ultérieur d'une couche sur un autre support ou substrat, il est connu de chercher à maîtriser les énergies de liaisons entre la couche et le substrat, comme indiqué dans le document EP 0702609 A1 .

Selon la connaissance acquise par ailleurs par les inventeurs de ce brevet, on peut également, pour réaliser un substrat démontable, utiliser des méthodes mettant en jeu le contrôle des forces de collage existant à la surface de « démontage » pour assembler provisoirement la couche fine et le substrat duquel on devra la démonter ultérieurement. Le cas où le collage est obtenu par adhésion moléculaire est un cas particulier intéressant. Parmi les catégories d'assemblages réalisés par collage moléculaire, les substrats SOI (Silicon On Insulator) réalisés par ces techniques de collage représentent une catégorie particulièrement intéressantes. Cette catégorie présente plusieurs variantes dont les principales sont décrites dans le livre « Semiconductor Wafer bonding Science and Technology », (Q.-Y. Tong and U. Gôsele, a Wiley Interscience publication, Johnson Wiley & Sons, Inc.). Certaines variantes sont connues sous la dénomination BSOI (Bonded SOI) ou encore BESOI (Bond and Etch Back). Ces variantes reposent, outre sur un collage comprenant l'adhésion moléculaire, sur un enlèvement physique du substrat initial soit par des techniques de type polissage et/ou des techniques de gravure chimique. D'autres variantes, en partie décrites auparavant comme technique de transfert de couche, reposent en plus du collage par adhésion moléculaire sur la séparation par "découpe" le long d'une zone fragilisée telles que les méthodes décrites dans les documents US-A-5374564 (ou EP-A-533551), US-A-6020252 (ou EP-A-807970) (séparation le long d'une zone implantée) ou encore dans le document EP 0925888 (séparation par fracture le long d'une couche enterrée porosifiée). Quelque soit la technique exacte utilisée, ces variantes ont pour point commun d'utiliser un collage moléculaire, mis en oeuvre dans la plupart des cas rencontrés dans la littérature entre deux substrats comprenant en leur surface à mettre en contact du silicium (Si) ou de l'oxyde de silicium (SiO2). D'autres matériaux se rencontrent parfois (Nitrures, silicures, etc ..).

On connaît, d'après le document EP - 0 938 129, un procédé selon lequel on procède à une séparation entre deux substrats collés l'un à l'autre au niveau d'une interface, au sein d'une couche poreuse formée à faible distance de l'interface ; de manière à faciliter l'action de séparation par un outil ou un jet appliqué en périphérie tout en ayant une bonne tenue mécanique dans la majeure partie de la zone de séparation, la tenue mécanique au niveau de cette couche poreuse de séparation n'est pas uniforme ; dans tous les exemples, la tenue mécanique est plus faible en périphérie qu'en partie plus centrale. Le document EP 1 059 663 décrit, dans un contexte similaire, un procédé selon lequel on forme une couche monocristalline sur une couche poreuse portée par un substrat, on enlève la portion périphérique de cette couche monocristalline et éventuellement la partie correspondante de la couche poreuse, puis on colle la couche monocristalline à un autre substrat ; il importe peu que cette partie périphérique de la couche poreuse soit effectivement poreuse ou non, puisqu'elle est enlevée avant collage. Dans ces divers cas, la séparation a lieu dans une couche poreuse située à une certaine distance de l'interface de collage et, lorsqu'il y a une différence de tenue mécanique, elle est plus faible (voire nulle) en périphérie.

Dans le cas où des structures non démontables de type SOI veulent être obtenues, les préparations de surface sont destinées à fournir à terme, et souvent à l'aide d'un recuit réalisé après le collage, de fortes énergies de collage, typiquement 1 à 2 J/m². Classiquement, avec des préparations standard, l'énergie de collage de la structure atteint l'ordre de 100 mJ/m² à température ambiante, et de 500 mJ/m² après un recuit à 400°C pendant 30 mn, dans le cas d'un collage SiO₂/SiO₂ (énergie de collage déterminée par la méthode de la lame développée par Maszara (Voir : Maszara et al., J Appl. Phys., 64 (10), p. 4943, 1988). Lorsque la structure est recuite à haute température (1100°C), l'énergie de collage peut atteindre 2 J/m² (C. Maleville et al., Semiconductor wafer bonding, Science Technology and Application IV, PV 97-36, 46 The Electrochemical Society Proceedings Series, Pennington, NJ (1998)). D'autres préparations avant collage existent, par exemple par exposition des surfaces à coller à un plasma (d'oxygène par exemple), et peuvent mener à des énergies équivalentes de collage sans toujours nécessiter de tels recuits (YA. Li and R.W. Bower, Jpn. J: Appl. Phys., vol 37, p. 737, 1998)

Par opposition, les inventeurs se sont intéressés au cas des structures de type SOI démontables. Or, il a été démontré qu'en jouant sur l'hydrophilie et la rugosité des surfaces, des tenues mécaniques différentes peuvent être obtenues. Par exemple, l'attaque HF permet, comme indiqué dans l'article de O. Rayssac et al. (Proceedings of the 2nd International Conference on Materials for Microelectronics, IOM Communications, p. 183, 1998), d'augmenter la rugosité d'une couche d'oxyde de Silicium. Dans cet article, il est décrit qu'une gravure de 8000 Å augmente la rugosité de 0,1 nm RMS à 0,625 nm RMS. Il a été vérifié qu'un collage SiO₂/SiO₂ avec des rugosités de 0,625 nm RMS et de 0,625 nm RMS pour les surfaces en regard, conduit à une valeur d'énergie de collage de l'ordre de 500 mJ/m² après un recuit à 1100°C, c'est-à-dire largement plus faible que dans le cas standard précité. Dans ce cas, les inventeurs ont démontré qu'on pouvait tirer profit de cette rugosification pour mettre au point des interfaces de collage démontables, même après des recuits à haute température, jusqu'à 1100°C. En combinant de manière astucieuse la préparation de rugosification avant collage avec des traitements de recuits thermiques adaptés, il a été ainsi démontré que des substrats de type SOI démontables pouvaient supporter, sans séparation inopinée au niveau de l'interface d'assemblage, l'essentiel des étapes d'un procédé de réalisation de transistors CMOS (comprenant notamment des étapes de traitement thermique à haute température, typiquement 1100°C, ainsi que des étapes de dépôt de couches contraintes, par exemple de nitrure), et pouvait à posteriori être démontées selon l'interface de collage par l'application volontaire de contraintes mécaniques contrôlées.

Pour faciliter l'action d'un outil ou d'un fluide sur la périphérie d'une structure en vue d'une séparation le long d'une interface, le document WO - 01/04933 propose un procédé de décollement de deux éléments selon lequel on ménage une cavité auprès de la périphérie de cette Interface ; il est mentionné la possibilité de faire varier l'énergie de collage, plus précisément en sorte de définir une zone centrale de l'interface où l'adhérence sera plus forte qu'en périphérie.

### Problème technique et solution de l'invention

La délamination est un problème parasite classique dans le cadre des structures multicouches, notamment dans le domaine des techniques de fabrication de composants microélectronique, capteurs etc... En effet, les traitements thermiques, les traitements chimiques (attaque HF,...), les opérations d'enlèvement mécanique et/ou physique de matière (polissage etc.., ...) nécessaires à la réalisation de composants, les étapes de dépôt et/ou de croissance épitaxiale, ou encore les contraintes mécaniques engendrés lors de la réalisation d'empilements non-homogènes engendrent souvent des clivages en bord de couche ou des amorces de décollement sur le bords de structures. Si on prend comme exemple le SOI, les nombreux traitements HF utilisés pour désoxyder le Si superficiel peuvent conduire dans certains cas à une surgravure importante de l'oxyde enterré et donc à fragiliser le film superficiel en bord de plaquette.

De l'état de la technique est également connu de EP0938129A1, EP1059663A2, WO01/04933A1 et FR2771852.

Les techniques de transfert de couches (avec ou sans composant) reposant sur la réalisation de substrats démontables par formation d'une couche intermédiaire ou interface fragilisée (qu'elle soit obtenue notamment par fragilisation par implantation d'espèces, par formation d'une zone poreuse, par contrôle de l'énergie de collage etc..) se heurtent à cet égard à certains problèmes liés à une délamination intempestive lorsque les traitements préalable à la séparation volontaire sont trop agressifs. Au cours du procédé de fabrication de tout ou partie du composant, il peut apparaître en ces bords, de façon involontaire, des amorces de fissure qui peuvent engendrer des pertes de rendement. Mis à part la diminution de surface du film actif due au pelage du film en bord, ces problèmes peuvent conduire à une forte augmentation de la contamination particulaire sur les plaquettes, et donc à une importante perte de rendement dans la fabrication des composants ainsi qu'à une contamination des équipements utilisés (en particulier les fours).

L'invention a pour objet de pallier les inconvénients précités, grâce à une interface couche/substrat qui permette de combiner, de façon fiable, l'impératif de séparation aisée, le moment voulu, et l'impératif de pouvoir, le cas échéant, supporter l'application de traitements thermiques ou mécaniques nécessaires pour la réalisation de tout ou partie de composants microélecronique, optique, acoustique ou de capteurs ou encore d'étapes d'épitaxie, sans provoquer de délamination ou de séparation prématurée.

Plus généralement, l'invention a pour objet un ensemble comportant une couche mince sur un substrat, cette couche étant reliée à ce substrat par une interface présentant un niveau de tenue mécanique qui peut être contrôlé. Elle propose à cet effet, tout d'abord, un procédé de préparation d'une couche mince comportant une étape de réalisation d'une interface entre cette couche mince et un substrat, caractérisé en ce que cette interface est réalisée en sorte de comporter une première zone ayant un premier niveau de tenue mécanique et au moins une seconde zone ayant un second niveau de tenue mécanique sensiblement supérieur au premier niveau.

En d'autres termes l'invention propose un procédé qui permet d'obtenir une structure possédant une structure enterrée (interface) dont la tenue mécanique est plus forte dans une zone que dans une autre. Cela permet, en fonction des besoins, de réaliser de façon optimale l'interface compte tenu des traitements qu'il est prévu de lui permet, en fonction des besoins, de réaliser de façon optimale l'interface appliquer.

Par tenue mécanique, il faut entendre qu'il peut s'agir, dans la totalité de ce document, de tenue mécanique au sens « résistance de matériaux », mais qu'il peut aussi s'agir de manière plus générale de susceptibilité à la rupture ou à la dissociation d'un milieu continu ou non (telle une interface ou un empilement, qui pourrait faire l'objet d'une délamination par exemple, etc ..), que ce soit face à une contrainte mécanique pure (traction, flexion, cisaillement, compression, torsion, etc..) ou lors d'un traitement thermique ou lors d'une attaque chimique, ainsi que toutes les combinaisons qui peuvent être réalisées. Conformément au problème particulier examiné ci-dessus, pour pouvoir démonter, au bon moment (mais pas avant), le substrat vis-à-vis de la couche, la première zone ayant un niveau de tenue mécanique plus faible est une zone entourée par la seconde zone. De manière préférée, surtout dans le cas où l'on souhaite réaliser le transfert de l'ensemble de la couche fine à l'échelle du substrat, la zone de plus forte tenue mécanique est une couronne (annulaire dans le cas de substrats ronds), dont la largeur peut varier de quelques centaines de micromètres à quelques millimètres, voire de l'ordre du cm. C'est ainsi que la couronne peut constituer la périphérie d'une plaque (ronde, carrée, polygonale ou autre) dont le coeur est de plus faible tenue mécanique.

De manière préférée, dans un cas correspondant plutôt à une séparation par parties de la couche fine (par puces, par composants ou ensemble et sous-ensembles de puces etc..) la préparation de cette couche comporte une étape selon laquelle on isole sur le substrat au moins une parcelle de cette couche, et cette seconde zone est conçue en sorte de longer le contour de cette parcelle. C'est ainsi que la première zone peut être parcellaire, chaque parcelle étant entourée d'une zone de plus forte tenue mécanique.

Ainsi, l'interface réalisée entre la couche mince et le substrat est, du point de vue tenue mécanique, plus faible en sa partie centrale qu'en sa périphérie. Les risques de délamination intempestive sont ainsi fortement réduits.

Cette interface (ou cette couche enterrée) peut être de différentes natures. Elle est définie comme étant une interface de collage (avec ou sans colle, par adhésion, moléculaire par exemple) , et avec ou non une couche intermédiaire (oxyde, nitrure).

La différenciation entre les zones de liaison à tenue mécanique plus ou moins fortes ou autre natures de liaisons différentes peut être réalisée par des énergies de liaison obtenues par exemple par des différences de préparation avant collage (rugosité, différences de caractère hydrophile, états des liaisons chimiques de surface, ...) et/ou par des différences de traitements thermiques, notamment après la mise en contact du collage.

Plus précisément, dans le cas où deux zones seulement sont présentes, selon des caractéristiques préférées de l'invention, éventuellement combinées (la seconde zone entoure donc la première zone) :
- après l'étape de réalisation de l'interface sont effectuées une étape d'isolation d'une parcelle de la couche contenant cette première zone et cette seconde zone de telle sorte que cette seconde zone longe la périphérie de cette parcelle, puis une opération de selon laquelle on décolle le substrat et la couche mince ; dans ce cas, dans certains cas, l'étape de décollement est avantageusement précédée d'une étape de délimitation physique de la seconde zone vis-à-vis de la première zone, par exemple après découpe partielle ou totale, par gravure chimique totale ou partielle, par fracture mécanique totale ou partielle etc.
- L'interface est réalisée entre une surface du substrat et une surface de la couche, et l'étape de réalisation de l'interface comporte une étape de préparation d'au moins l'une de ces surfaces, une étape de collage selon laquelle cette surface est collée à l'autre surface par collage par adhésion moléculaire ; de manière préférée, l'étape de réalisation de l'interface comporte avantageusement une étape de préparation pour chacune des surfaces du substrat et de la couche. De manière préférée, l'étape de préparation de surface comporte une étape de traitement selon laquelle, par exemple, on diminue le caractère hydrophile ou on augmente localement la rugosité de cette surface en cette première zone ; il s'agit par exemple d'une attaque acide localisée de la surface en cette première zone ; plus précisément, de manière encore plus préférée, l'une au moins de surfaces comporte une couche d'oxyde et l'attaque acide est effectuée avec de l'acide HF, la surface étant, en cette seconde zone, protégée de cette attaque par une couche de protection (par exemple en nitrure) qui est éliminée après l'attaque. Dans une autre variante, la surface d'au moins une des deux plaques est rendue entièrement rugueuse, et sur certaines parties, la rugosité est ensuite modifiée, essentiellement dans le sens d'une amélioration, pour obtenir des forces de collage plus grandes, par exemple à l'aide de traitements de polissage chimique ou de traitements mécaniques ou mécano-chimiques ou ioniques, ou encore par gravure sèche.
- Pour préparer la surface en contrôlant la rugosité, on peut par exemple, notamment lorsque l'une des surfaces est un oxyde, utiliser une attaque partielle acide effectuée avec de l'acide HF.
- La tenue mécanique et/ou chimique de l'interface ou couche de liaison est modifiée à l'aide de traitements thermique non-uniformes permettant de renforcer sélectivement ou au contraire affaiblir sélectivement certaines zones plus que d'autres selon qu'il s'agisse d'un collage de surfaces rugosifiées, de matériaux poreux, de défauts enterrés, de micro-cavités gazeuses ou non.
- L'étape de réalisation de l'interface est suivie d'une étape de démontage de la couche vis-à-vis du substrat. De manière avantageuse, entre l'étape de réalisation de l'interface et l'étape de décollement, une étape de collage est effectuée, au cours de laquelle la couche est collée à un second substrat. Cette étape de collage comporte, avantageusement, un collage par adhésion moléculaire ou un collage par adhésif (par exemple par une colle durcissable par rayonnement UV, une résine, une colle polymère). Dans ces cas, l'étape de démontage est avantageusement réalisée par attaque acide et/ou application de contraintes mécaniques.
- La couche est en matériaux semi-conducteurs (Si, Ge, SiGe, SiC, GaN et autres nitrures équivalents, AsGa,InP, Ge..) ou en matériaux ferroélectriques ou piézoélectriques (LiNbO₃, LiTaO3) ou magnétiques « processés » ou non.
- La couche mince présente sur le substrat démontable a été obtenue par amincissement d'un substrat initial du matériau semi-conducteur.
- L'amincissement est obtenu par rectification et/ou polissage mécano-chimique ou non et/ou attaque chimique.
- La couche mince présente sur le substrat démontable a été obtenue par découpe dans le substrat initial du matériau semiconducteur.
- La découpe est obtenue par une découpe au niveau d'une couche fragile enterrée.
- La couche fragile enterrée est obtenue par implantation et la séparation est obtenue par traitement thermique et/ou mécanique et/ou chimique.
- L'espèce Implantée est une espèce gazeuse (Hydrogène, Hélium...)

En terme de produit, l'invention propose un er une couche sur un substrat, cette couche, étant reliée à interface dont au moins une première zone choisie a un sensiblement supérieur au premier niveau, la seconde première zone.

### Brève description des dessins

Des objets, caractéristiques et avantages de l'invention ressortent de la description qui suit, donnée à titre d'exemple illustratif non limitatif en regard des dessins annexés sur lesquels ;
- la figure 1 est une vue schématique en vue de dessus partielle d'une face sur laquelle deux zones sont préparées en sorte d'avoir des caractéristiques de collage moléculaires différentes,
- la figure 2 est une vue en coupe selon la ligne II-II de la figure 1,
- la figure 3 est une vue d'un ensemble comportant une couche mince sur un substrat, suivant une interface du type de la figure 1,
- la figure 4 est une vue schématique en coupe de l'ensemble d'une couche mince sur un substrat,
- la figure 5 est une vue en coupe d'une plaquette de substrat muni d'une couche protectrice,
- la figure 6 est une vue de la plaquette de la figure 5 après évidement,
- la figure 7 est une vue de cette plaquette après remplissage de l'évidement par un dépôt d'oxyde,
- la figure 8 est une vue de cette plaquette recouverte du dépôt, après polissage,
- la figure 9 est une vue de cette plaquette après élimination du surplus du revêtement d'oxyde,
- la figure 10 est une vue de cette plaquette après fixation de la couche mince, ou après fixation d'une couche épaisse puis amincissement de celle-ci,
- la figure 11 est une variante de l'ensemble de la figure 10, dans laquelle le revêtement d'oxyde pénètre dans le substrat ainsi que dans la couche mince,
- la figure 12 est une variante de l'ensemble de la figure 10 dans laquelle le revêtement d'oxyde est prévu dans la couche mince,
- la figure 13 est une variante de l'ensemble de la figure 11 dans laquelle l'oxyde occupe des zones différentes dans le substrat et dans la couche mince,
- la figure 14 est une variante dans laquelle l'interface est formé d'une couche formée, selon les zones, par des matériaux différents (ici SiO2 et Si3N4),
- la figure 15 est une variante de la figure 10, montrant une pluralité de zones formées par l'oxyde,
- la figure 16 est une variante de la figure 14, montrant une couche intermédiaire formée d'une pluralité de zones de matériaux différents,
- la figure 17 est une variante montrant des couronnes Z1 et Z2 concentriques et alternées,
- la figure 18 est une variante montrant un réseau de zones Z1 dans une zone globale Z2,
- la figure 19 est une vue schématique de l'ensemble de la figure 4 après dépôt d'une couche superficielle,
- la figure 20 est une autre vue après collage moléculaire d'un substrat final,
- la figure 21 est une autre vue après application d'une action de décollement,
- la figure 22 est une vue schématique d'une plaquette obtenue après décollement et un polissage,
- la figure 23 est une vue d'un ensemble démontable du type de la figure 4,
- la figure 24 en est une vue après réalisation de tout ou partie de composants, par exemple de la première grille de transistor,
- la figure 25 en est une vue après dépôt d'oxyde,
- la figure 26 en est une vue après planarisation par CMP,
- la figure 27 en est une vue après collage par adhésion moléculaire (y compris traitement thermique,
- la figure 28 en est une vue après démontage et désoxydation,
- la figure 29 est une vue d'un ensemble démontable du type de la figure 4,
- la figure 30 en est une vue après réalisation de composants,
- la figure 31 en est une vue après démontage sans report sur substrat cible, par gravure HF et/ou application d'efforts mécaniques,
- la figure 32 en est une vue après démontage en un substrat final et un substrat recyclable,
- la figure 33 est une variante de la figure 30, après découpe de tranchées ou d'entailles entre les composants,
- la figure 34 en est une vue montrant un composant en train d'être décollé, par exemple après gravure HF,
- la figure 35 est une vue analogue à la figure 4,
- la figure 36 est une vue schématique en coupe de l'ensemble de la figure 35 après collage par adhésif d'un substrat transparent,
- la figure 37 est une vue de la partie supérieure de cet ensemble après décollage et polissage,
- la figure 38 est une vue de la partie supérieure de cet ensemble après décollage et polissage,
- la figure 39 est une vue d'un ensemble analogue à celui de la figure 4 visualisant des zones sont éliminées par détourage mécanique et chimique,
- la figure 40 en est une vue après collage d'un substrat supérieur,
- la figure 41 est une vue agrandie d'un ensemble comportant des zones Z1 et Z2 intercalées,
- la figure 42 est une vue d'un ensemble analogue à celui de la figure 4,
- la figure 43 en est une vue après dépôt d'un empilement épitaxial à base de GaN,
- la figure 44 en est une vue après collage d'un substrat,
- la figure 45 en est une vue au moment d'un décollement,
- la figure 46 en est une vue de la partie supérieure après polissage,
- la figure 47 en est une vue après enlèvement de la couche sous l'empilement,
- la figure 48 est une vue d'un substrat comportant une couche fragile enterrée, et
- la figure 49 est une vue d'un substrat comportant une portion de couche fragile enterrée.

### Description de l'invention

### 1- interface de collage par adhésion moléculaire

Les exemples privilégiés qui seront retenus pour les descriptions détaillées concerneront principalement le cas du silicium, généralement disponible sous forme de substrats ronds, par exemple en diamètre de 200mm. De manière non-limitative, ces procédés se transfèrent aisément sans sortir du contexte de l'invention à d'autres systèmes caractérisés en particulier par des matériaux autres que le silicium.

Parmi les différents modes de mise en oeuvre du procédé selon l'invention, certains tendent à favoriser un décollement de la couche de son substrat au niveau global, c'est à dire à l'échelle de la totalité du substrat, tandis que d'autres tendent à délimiter des parcelles.

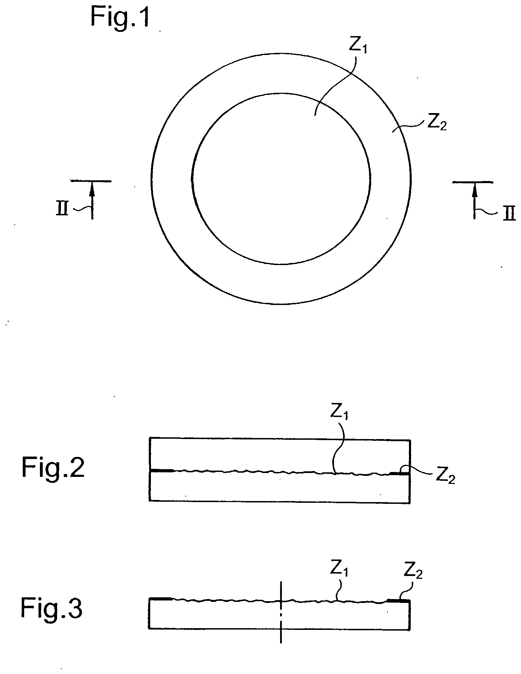

Dans le premier cas, un ensemble que l'on cherche à réaliser se retrouve schématiquement en figure 1 et 2, l'interface (ou la couche intermédiaire) schématisée sur la figure 2 représentant la région dans laquelle on va chercher à créer des différences locales quant à la liaison. En plus de ces figures, la figure 3 en particulier représente un exemple de la préparation d'une face destinée à participer à une interface ayant, conformément à l'invention, deux zones ayant des tenues mécaniques différentes. Plus précisément, dans cet exemple représenté, le but est d'obtenir une zone centrale Z1 de tenue mécanique E_{c1} inférieure à celle, E_{c2}, d'une zone périphérique Z2, entourant cette zone centrale.

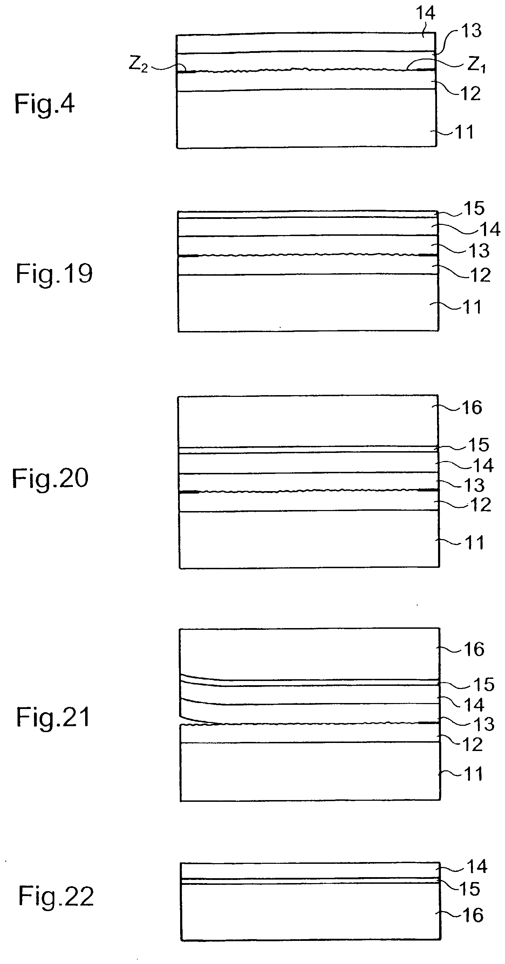

Dans le but d'obtenir une énergie de collage supérieure en périphérie Z2 par rapport au centre Z1, différentes méthodes peuvent être utilisées. Les exemples de collages SiO₂/SiO₂ et Si/SiO₂ vont être considérés. Dans le cas de natures de couches différentes (Si3N4 est un autre exemple classique, mais aussi les siliciures), il suffit, par analogie avec ce qui va suivre, d'utiliser des traitements chimiques adaptés (par exemple NH₄OH/H₂O₂/H₂O (appelé aussi SC1) pour le Si et H₃PO₄ ou HF pour le Si₃N₄). La figure 4 représente l'option où le substrat 11 et la couche mince 14 sont en silicium monocristallin, et où deux couches intermédiaires 12 et 13 ont été formées préalablement au collage sur le substrat 11 et la couche mince 14 respectivement. Bien entendu, l'une seulement des deux couches intermédiaires 12 ou 13 peut suffire, ou encore le cas où aucune des deux n'existe (collage Si/Si) doit être considéré correspondant ainsi à deux cas particuliers. Dans le cas où ces couches intermédiaires 12 et 13 existent et sont toutes deux en SiO2, on dénomme le système par collage SiO2/SiO2. Dans le cas où l'une seule des deux existe et est en SiO₂, on dénomme le système par collage Si/SiO2.

Dans le but de réaliser une structure telle que celle décrite en figure 4, et au delà des aspects techniques liées au collage par adhésion moléculaire, plusieurs techniques peuvent être employées dont celles déjà cités auparavant pour la réalisation de substrats SOI non démontables (voir Semiconductor Wafer Bonding , Science and Technology, Q. Y. Tong et U. Gösele, Wiley Interscience Publication). Par la suite on appellera la couche 14 la couche active, représentant la couche qui comprendra les composants sauf pour certains cas particuliers pour lesquels une couche additionnelle épitaxiale par exemple sera déposée sur cette couche 14. Dans certaines variantes de l'invention, la couche mince est obtenue par amincissement mécanique et/ou chimique de la structure. Ces variantes sont connues sous la dénomination BSOI (Bonded SOI) ou encore BESOI (Bond and Etch Back). Ces variantes reposent, outre sur un collage comprenant l'adhésion moléculaire, sur un enlèvement physique du substrat initial soit par des techniques de type polissage et/ou des techniques de gravure chimique. D'autres variantes, en partie décrites auparavant comme technique de transfert de couche, reposent en plus du collage par adhésion moléculaire sur la séparation par "découpe" ou clivage le long d'une zone fragilisée telles que les méthodes décrites dans les documents US-A-5374564 (ou EP-A-533551), US-A-6020252 (ou EP-A-807970) et (séparation le long d'une zone implantée) ou encore dans le document EP 0925888 (séparation par fracture le long d'une couche enterrée porosifiée).

Concernant les aspects spécifiques liés au collage pour la réalisation de substrats démontables, dans le cas du collage SiO2/SiO2 (ou encore Si/SiO2), on peut tout d'abord utiliser un masque temporaire qui permet de déposer une couche de protection, par exemple en nitrure Si₃N₄, seulement sur la couronne de la couche d'oxyde SiO₂ 12 et/ou 13. Cette couche d'oxyde peut avoir été préparée de plusieurs manières (dépôt, oxydation thermique du silicium) et présenter une épaisseur variable selon l'application. Pour cet exemple, nous pouvons choisir un oxyde thermique d'épaisseur 1µm. On obtient ainsi la structure suivante : la surface du disque central est formée d'oxyde seul tandis que la surface de la couronne extérieure (typiquement, de quelques mm de large) est formée ce cet oxyde recouvert d'une couche de protection supplémentaire (en nitrure par exemple).

On procède ensuite à une attaque HF dont le but est de rugosifier la surface de l'oxyde, rugosification dont l'importance sera croissante avec l'épaisseur d'oxyde enlevée. Pour chaque application, l'importance de cette rugosification peut être optimisé, notamment en fonction du cahier des charges du procédé de réalisation des composants (ou de croissance épitaxiale) qui devra être formé sans délamination et du mode retenu de mise en ouvre du démontage final. Typiquement, un enlèvement par attaque HF d'une épaisseur d'oxyde de l'ordre de quelques centaines à quelques milliers d'Å est un bon compromis de départ. Une épaisseur de l'ordre de 1000 Å de nitrure permet de protéger l'oxyde se trouvant au-dessous de toute attaque par HF. Cette attaque augmente la rugosité de la zone centrale de la couche d'oxyde 12 et/ou 13. L'enlèvement du nitrure, ensuite, se fait, par exemple, par attaque à l'acide ortophosphorique (H₃PO₄) chaud (>110°C). A cela, on peut coupler un nettoyage humide ou sec sélectif pour obtenir une hydrophilie différente entre Z1 et Z2. On obtient ainsi un effet allant dans le sens d'un collage à tenue plus faible que le collage standard au centre et à tenue identique au cas standard à l'emplacement de la couronne.

Dans le cas où l'épaisseur d'oxyde enlevée devient importante, notamment parce que l'application le demande (notamment dans la gamme des quelques milliers d'A, sachant que 5000 Å est un bon compromis de départ pour de nombreux cas), il faut noter qu'outre l'effet recherché d'augmentation locale de la rugosité, il en résulte la création d'une différence de niveau entre la zone centrale (qui a subi l'attaque HF) et la couronne (qui a été préservée de cette attaque). Pour obtenir un collage de très bonne qualité au niveau de la couronne en combinaison avec un collage de qualité satisfaisante dans la zone centrale, il peut être nécessaire, dans certains cas, de faire disparaître ou amoindrir cette différence de niveau. Pour cela, il peut être judicieux d'utiliser un polissage (de type mécano-chimique par exemple). Du fait de la différence de niveau, un polissage à priori uniforme résulte, par effet planarisant bien connu dans le domaine de la micro-électronique, en un polissage préférentiel sur le zone émergente, c'est-à-dire dans la zone de la couronne dans le cas présent. Mais ce polissage peut aussi être volontairement localisé à la couronne. On peut de façon préférentielle polir la couronne par exemple en utilisant un tissu de polissage évidé au centre dans le cas ou le substrat est circulaire, permettant ainsi de ramener le niveau de la couronne à celui de la zone centrale attaquée par le HF. De plus, on sait que le polissage conduit à des énergies de collage supérieures à celles obtenues par collage par adhésion moléculaire classique (sans polissage). On combine ainsi deux effets allant dans le sens d'un collage à tenue plus faible que le collage standard au centre et à tenue plus forte, à l'emplacement de la couronne. Un tel ensemble est un autre cas particulier correspondant à la figure 3. Une autre façon de ramener le niveau de la couronne à celui du centre peut être de réaliser une gravure localisée de type humide ou sèche.

Une alternative consiste à rugosifier l'ensemble de la couche intermédiaire 12 et/ou 13, c'est à dire sans protéger la couronne, mais à ajouter localement au niveau de cette couronne un traitement qui augmentera significativement la tenue du collage. Parmi ces traitements, on peut citer par exemple l'emploi d'un traitement plasma Oxygène, d'un recuit localisé dont un des buts serait par effet de fluage de reconstruire et d'en réduire la rugosité la surface de l'oxyde ou tout autre traitement connu de l'homme du métier visant à améliorer la cohésion de l'assemblage. Ces traitements ont l'avantage de ne pas créer de relief.

Une autre alternative concerne l'emploi de recuits thermiques localisés (faisceau laser, fours non-uniformes, chauffage par lampe etc ..) après l'opération de collage. En effet, comme on peut le constater dans C. Maleville et al., Semiconductor wafer bonding, Science Technology and Application IV, PV 97-36, 46 The Electrochemical Society Proceedings Series, Pennington, NJ (1998), une différence de température de recuit après collage d'une centaine de degré peut mener, surtout dans le domaine des températures au delà de 800°C à une variation significative de l'énergie de collage. Cette alternative peut-être utilisée seule ou en combinaison d'une rugosification d'une couche intermédiaire au moins 12 et 13 ou seule, (c'est à dire sans étape de rugosification du tout). Un exemple très précis, mais qui doit en aucune manière être considéré comme limitatif, de mise en oeuvre pour un collage SiO2/SiO2 est de recuire l'ensemble de la structure à 1000°C mais de chauffer sélectivement la couronne à 1200°C. Un autre est de ne pas recuire du tout la couronne, à une température de 1000°C. Pour cette alternative de recuits sélectifs, il est entendu que, du fait des phénomènes de conduction thermiques et de la difficulté à réaliser des équipements qui chauffent localement avec une sélectivité parfaite, un chauffage localisé peut résulter en un gradient d'apport de chaleur. Dans ce cas, la température de recuit peut être considéré comme maximum aux bords du substrat et chutant au fur et à mesure que l'on se rapproche du centre du substrat.

Une autre variante pour la réalisation d'un substrat démontable peut être basée sur une différence de nature chimique entre la zone Z1 et la zone Z2. Nous pouvons par exemple citer, de manière non exhaustive, les couples suivants : Z1=SiO2 et Z2= Si ; Z1=Si3N4 et Z2=SiO2, Z1=Si3N4 et Z2=Si etc ... Nous allons seulement décrire le cas du couple Z1=SiO2 et Z2= Si.

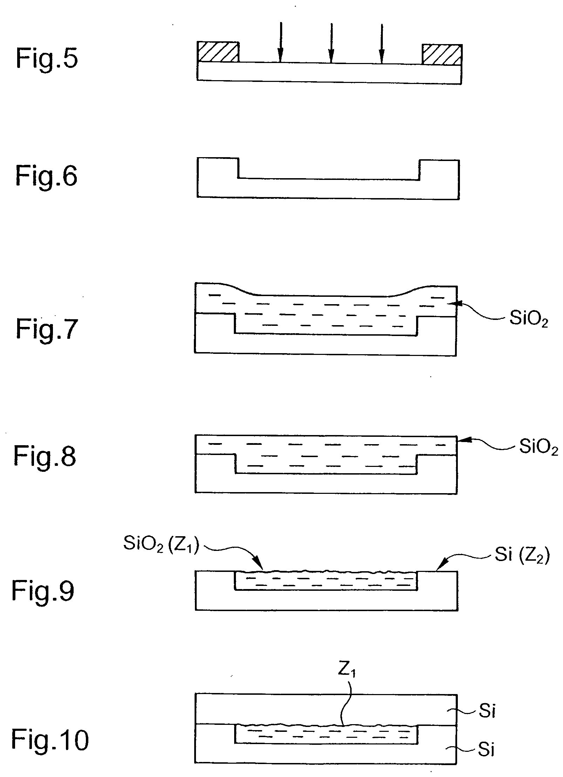

Sur un substrat de silicium, une couronne protectrice (résine, dépôt PECVD,...) de quelques mm de largeur est déposée de manière à définir les dimensions de la zone Z2, comme le montre la figure 5.

La structure est ensuite gravée (gravure humide ou sèche selon les techniques classiquement employées pour graver le silicium) de telle sorte que cette gravure n'attaque que la région non protégée. On peut aussi envisager une attaque mécanique (fraisage, polissage ...) qui n'usinerait que le centre de par la configuration et/ou dimension de l'outil utilisé. Dans ces, l'opération de dépôt d'une couche de protection n'est plus indispensable. Quel que soit la méthode, nous obtenons une plaquette de silicium évidée en son centre (avec éventuellement une étape de retrait de la couronne protectrice), comme le montre la figure 6.

Nous avons ainsi défini l'emplacement de la zone Z1 (disque évidé) et la zone Z2 (couronne extérieure).

Sur ce substrat évidé, un oxyde est déposé par CVD. L'épaisseur de la couche d'oxyde déposée est largement supérieure à la profondeur de l'évidement, menant au cas de la figure 7.

Un polissage planarisant va permettre d'éliminer la différence de niveau entre la couronne et le centre de la structure ainsi que la forte rugosité intrinsèque à ce type de dépôt (voir figure 8). Ensuite, une gravure HF est réalisée de manière à aboutir à la structure représentée en figure 9 . Dans ce cas, la gravure HF est arrêtée lorsque le silicium affleure en couronne. On se retrouve alors dans une configuration « silicium en couronne et oxyde rugosifié au centre », ce qui définit un différentiel d'énergie entre Z1 et Z2, d'une part car ces deux zones présentent une rugosité différente et d'autre part car la nature des matériaux est différente (propriétés de collage par adhésion moléculaire différente).

Suivant le différentiel d'énergie désiré entre Z1 et Z2, on peut modifier cette séquence pour aboutir à une configuration « silicium en couronne et oxyde non-rugosifié au centre ». Pour cela, on peut par exemple supprimer l'étape de gravure HF mais prolonger l'étape de polissage préalable jusqu'à l'affleurement lors du polissage de la couronne silicium. Dans ce cas, le différentiel d'énergie entre Z1 et Z2 repose essentiellement sur la différence de nature des matériaux . Dans ce cas-là, le différentiel est plus faible.

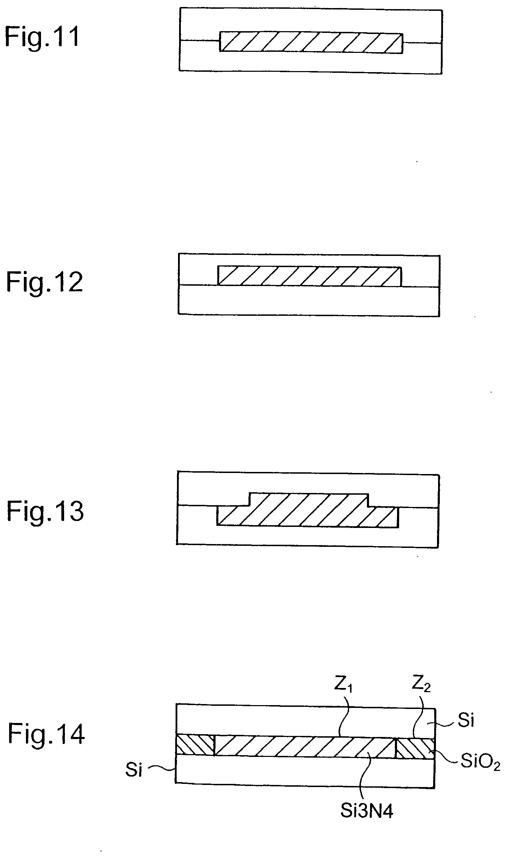

L'évidement et le dépôt d'oxyde ont été cités dans le cas où il sont réalisés sur le substrat 11 (on obtient après collage la configuration de la figure 10). Une variante consiste à réaliser ces opérations du coté de la couche mince 14 (voir la figure 12), voire des deux cotés (voir la figure 11). Pour d'autres couples de matériaux pouvant caractériser une différence de tenue mécanique, les procédés peuvent comporter quelques étapes supplémentaires. Par exemple si l'on cherche à obtenir le couple Z1=Si3N4 et Z2=SiO2, outre le dépôt d'oxyde, un dépôt de Si3N4 devra être réalisé en prenant soin de définir pour l'ensemble de la structure la couronne recherchée à l'aide de techniques classiques de masquage (photo-lithographie, méthodes mécaniques, ...etc ...). Cette structure a pour avantage de présenter une excellente sélectivité concernant l'attaque chimique entre les deux matériaux considérés (par exemple à l'aide de HF) qui pourra permettre de faciliter le démontage par un enlèvement aisé et sélectif par gravure chimique de la couronne.

D'autres configurations sont possibles ; ainsi par exemple :
- la figure 13 est une variante de la figure 11 où la couche centrale n'a pas les mêmes dimensions dans le substrat et dans la couche mince,
- la figure 14 représente un ensemble où la couche d'interface entre le substrat et la couche mince comporte une portion centrale Z1 et un matériau (Si3N4) différent de celui de la portion périphérique Z2(SiO2), ces deux portions étant en des matériaux différents de ceux du substrat et de la couche mince (ici en Si),

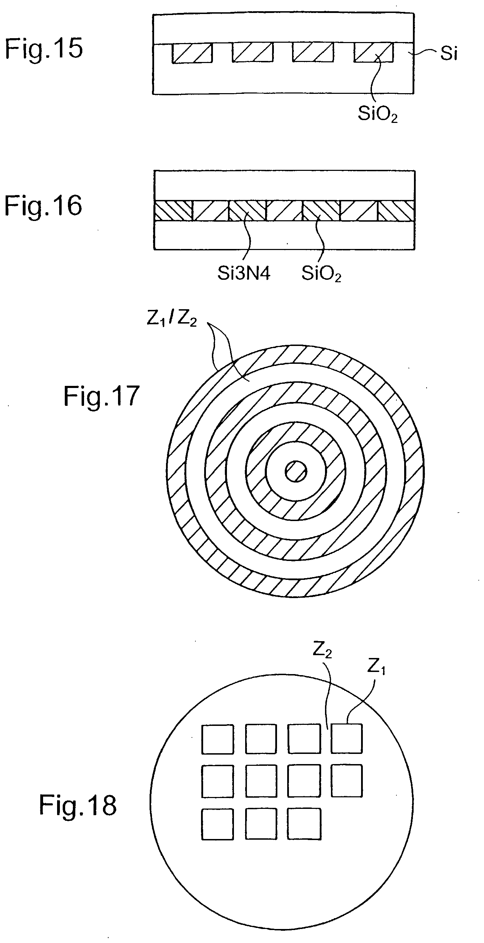

- la figure 15 est une variante de la figure 10 où il y a plusieurs zones Z1 en un matériau distinct du support,
- la figure 16 est une variante de la figure 14 où il y a plusieurs zones Z1 (et plusieurs zones Z2) en matériaux (ici Si3N4 et SiO2) différents de ceux du substrat et de la couche mince (ici Si).

Les figures 15 et 16 peuvent correspondre à plusieurs géométries dont les figures 17 et 18 donnent des exemples (au niveau puce ou pas),
- la figure 17 correspond à une configuration présentant une pluralité de bandes concentriques Z1 ou Z2, et
- la figure 18 correspond à une configuration présentant un réseau (en rangées et colonnes) de zones d'un type (ici Z1) dans une zone globale de l'autre type (Z2).

Au delà de la réalisation du substrat dit démontable lui-même à partir de techniques basées sur le collage moléculaire, plusieurs moyens existent quant à son utilisation et aux moyens de le mettre en oeuvre.

L'intérêt de ce substrat démontable est, suivant l'épaisseur de la couche active processée (c'est à dire traitée en sorte d'y réaliser tout ou partie d'un composant) ou non, de permettre la désolidarisation de la couche active pour obtenir, soit une couche autoportée (couche relativement épaisse, que cette épaisseur soit déjà présente dès la fabrication du substrat démontable ou lors d'étapes de dépôts postérieurs à sa fabrication comme c'est le cas lors d'une étape d'épitaxie), soit une couche superficielle en général plus fine reportée sur un support cible, qu'il soit le support définitif ou juste un support temporaire destiné à être lui-même démonté.

Un tel transfert de la couche superficielle sur le substrat cible peut être réalisé de différentes façons.

Tout d'abord, ce transfert peut être effectué par un nouveau collage par adhésion moléculaire de ce qui doit devenir la couche mince à transférer sur un autre substrat.

A titre d'illustration, nous allons décrire un procédé de démontage dans l'optique de réaliser une nouvelle structure de type SOI que l'on appellera ici deuxième SOI. Un tel procédé, à priori moins direct que les techniques évoquées ci-avant présente cependant quelques intérêts. L'exemple choisi ici concerne la réalisation d'une deuxième substrat SOI avec un oxyde enterré de 500Å, épaisseur qu'il est délicat d'obtenir avec un tel procédé mené en direct.

La première structure est obtenue selon l'une des voies décrites précédemment pour aboutir au substrat démontable correspondant à la figure 4. La couche 14 de silicium monocristallin pour cet exemple sera la future couche active. Sur ce substrat démontable dont la zone centrale de la couche de liaison ayant été d'une part rugosifiée avant collage et n'ayant d'autre part pas subi de traitement thermique de renforcement à des températures très élevées (préférentiellement inférieures à 1100°C et encore mieux en deçà de 1000, voire 900°C), un oxyde de 500Å est formé par oxydation thermique pour mener à la structure représentée en figure 19. Cet oxyde deviendra le futur oxyde enterré de la deuxième structure SOI. Ce substrat démontable (11+12+13+14+15) est, dans l'exemple considéré collé par adhésion moléculaire sur un substrat de silicium 16 (voir figure 20) qui deviendra le futur support final de la couche active. L'empilement obtenu est de préférence stabilisé à haute température (1100°C) pour consolider fortement le second collage à l'interface des couches 15 et 16. Ce second collage est classique en ce sens qu'il n'y a pas de différenciation entre des zones à tenue mécaniques différentes. Le premier collage subissant le même traitement aura cependant, au moins dans sa partie centrale correspondant à la zone Z1 une tenue mécanique inférieure au deuxième collage. Pour le décollement, on peut utiliser une méthode mécanique et/ou chimique. Ainsi, à titre d'exemple, on commence par plonger l'empilement obtenu dans un bain de HF, dont un des buts est de surgraver l'oxyde 12 et 13 en partant des bords de l'ensemble pour éliminer la couronne correspondant à la zone Z2 et déboucher sur la zone Z1. Les deux interfaces 12/13 et 15/16 vont être préférentiellement attaquées. De plus, l'interface 12/13 du substrat démontable est de façon avantageuse une interface oxyde/oxyde. Ainsi elle file plus facilement que l'interface 15/16 qui est entre de l'oxyde et du silicium. Donc, lors de cette étape de décollement de la couronne à tenue mécanique plus forte, on attaque moins de surface au niveau de l'interface du second collage qu'au niveau de l'interface du substrat démontable. Lorsque l'acide est arrivé au niveau de la zone à énergie faible (zone centrale) - voir la figure 21, une séparation à caractère mécanique (jet d'eau sous pression comme dans le document EP 0925888, jet d'air comprimé comme dans le document FR 2796491, traction comme dans le document WO 00/26000, insertion d'une lame... ) permet de libérer complètement la structure finale 13+14+15+16 (voir la figure 22). Suite à l'enlèvement de l'oxyde 13, par exemple par attaque HF, la structure finale SOI est enfin obtenue. La plaque 11 de Si, qui a servi de substrat au sein du substrat démontable, peut être recyclée et réutilisée, par exemple pour la réalisation d'un autre substrat démontable (après, de préférence, élimination de la couche 12).

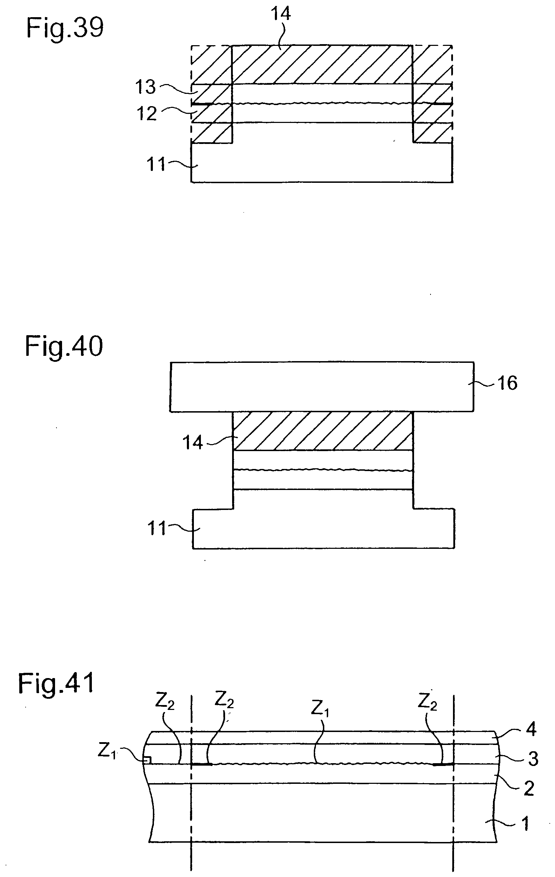

Pour l'élimination de la couronne afin d'avoir accès à la zone de tenue Z1, d'autres moyens peuvent consister à éliminer au moins partiellement la couronne. Pour ceci, les techniques de gravure chimiques, sèche ou humide, ou d'autres techniques mécaniques de polissage, de découpe laser etc.. peuvent être employées localement au niveau de la couronne (voir figures 39 et 40 qui correspondent à la réalisation d'un détourage (zone hachurée) mécanique ou chimique avant de coller le second substrat).

Il est à noter que l'oxyde enterré de 500Å 15 formé au préalable sur la couche 14 aurait pu être formée sur le substrat 16 avant collage et non sur la couche 14. Une autre variante eut consisté à diviser l'épaisseur de 500Å en deux parties pour former une partie sur le substrat 16, par exemple 250Å, et l'autre partie sur la couche 14, 250 Å dans l'exemple respectivement.

Il est à noter que si les deux interfaces collées par adhésion moléculaire sont tous deux du type oxyde/oxyde, la stabilisation du deuxième collage à haute température peut avoir été conduite en sorte de garantir que l'attaque HF se fait préférentiellement au niveau de la première interface. Dans ce procédé la création d'une zone Z1 à faible tenue mécanique a permis de séparer préférentiellement l'empilement complet selon la première interface de collage et la zone Z2 a permis d'une part de prélever une couche active 14 de bonne qualité et d'éviter d'autre part, des amorces de fissure qui peuvent engendrer des pertes de rendement, une diminution de surface du film actif due au pelage du film en bord, et donc une forte augmentation de la contamination particulaire sur les plaquettes.

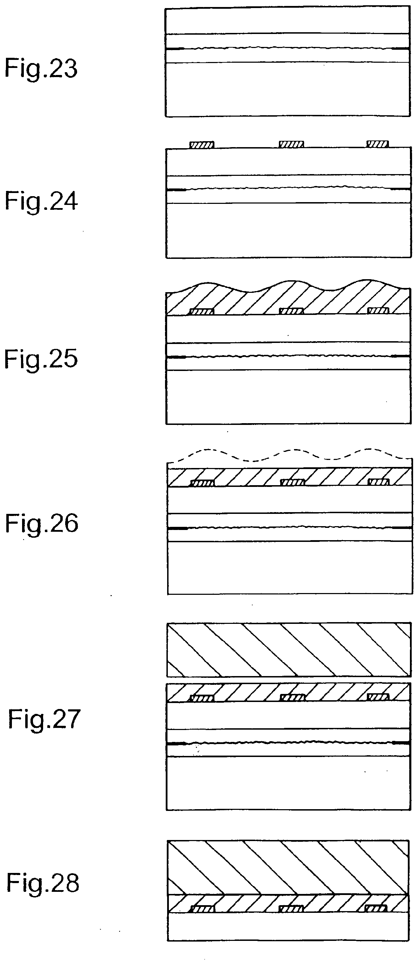

Un autre exemple qui ne fait pas partie de l'invention concerne la réalisation de structures de transistors dites à double grille. Les premières opérations liées à la fabrication des transistors consistent essentiellement à réaliser la première grille du transistor CMOS (voir figure 24) selon une technologie conventionnelle sur un substrat démontable (voir figure 23) tel que celui décrit en figure (4), identique en tout point au cas décrit ci-avant pour la réalisation de structures SOI à oxyde enterré fin. La température de stabilisation du collage peut éventuellement être réduite dans une gamme de température de l'ordre de 900/1000°C. Sur ce substrat est ensuite déposée (voir figure 25) une couche d'oxyde d'une épaisseur de l'ordre du µm par une technique conventionnelle de dépôt (CVD par exemple). Cet oxyde est planarisé selon une technique conventionnelle de polissage mécano-chimique (voir figure 26). Ensuite, on procède à un collage par adhésion moléculaire avec un autre substrat de silicium 16 (voir figure 27). Ce collage est stabilisé préférentiellement à une température de 1000 à 1100°C si les structures formées pour la première grille le supportent, à des températures de l'ordre de 900/1000°c sinon. Enfin l'on procède à la séparation (voir figure 28) de manière identique au cas précédent (insertion de lame, jet d'eau sous pression ou d'air comprimé etc..). Avant de reprendre le processus de fabrication du transistor, notamment pour la réalisation de la deuxième grille (sur le nouveau « substrat » représenté à la figure 28), le résidu de la couche d'oxyde 13 est enlevé par gravure chimique. Du fait de l'emploi d'une attaque de l'oxyde avec une solution d'acide HF dont on connaît la sélectivité d'attaque par rapport au silicium, la gravure s'arrête naturellement une fois que l'oxyde est entièrement gravé, permettant de retrouver une surface de silicium. Cette technique présente pour avantage majeur par rapport à d'autres techniques de fracture, obtenue par exemple grâce à une implantation, de ne pas nécessiter de séquences de finition trop complexes et délicates quant à leur potentiel de création de défauts tels que le présente par exemple une opération de polissage final. Le reste de la fabrication du transistor à double grille est à la portée de l'homme du métier.

Le même processus peut-être utilisé pour de nombreuses autres applications. Si la première structure SOI correspondant à la figure 4 est utilisée pour réaliser des transistors, circuits, composants etc.., ceux-ci peuvent être reportés en final sur de nombreux types de support spécifiques. Par exemple, le substrat 16 peut être choisi pour ses propriétés isolantes d'un point de vue électrique (silicium haute résistivité, Quartz, saphir,...) pour fournir un support idéal aux circuits hyperfréquences et de télécommunications, limitant ainsi les pertes dans le substrat. Pour des applications liées aux écrans plats, on choisira pour le support final un substrat transparent.

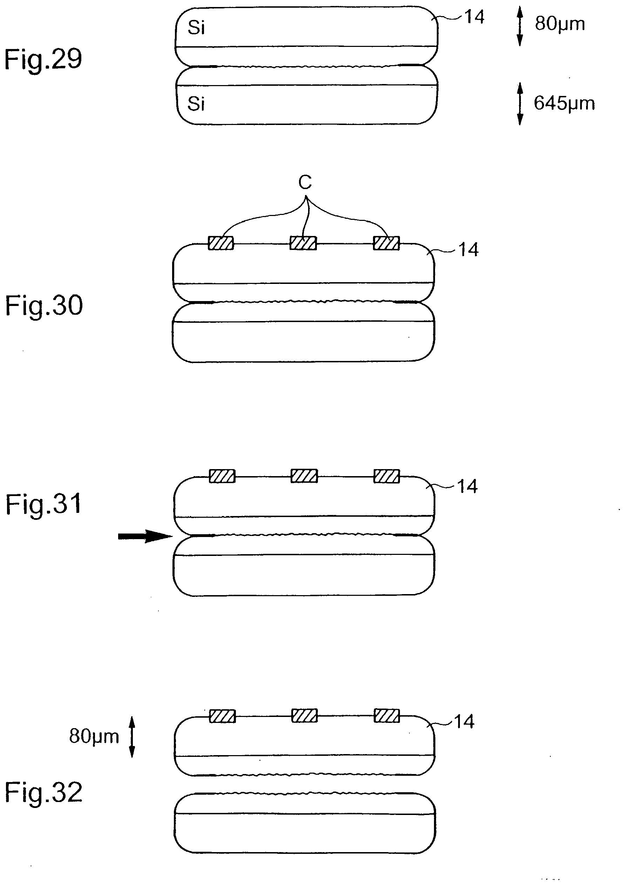

Un autre exemple de mise en oeuvre du démontage est brièvement décrit ici (figures 29 à 32) pour la réalisation de circuits sur substrats fins. Les épaisseurs d'intérêt en final sont typiquement en dessous de quelques centaines de µms, voire de l'ordre de quelques dizaines de µms. Elles concernent par exemple les applications de puissance ou les applications de carte à puce et autres circuits pour lesquels on recherche une certaine souplesse (supports plastiques, supports courbes, etc..). Dans une variante de cet exemple, nous nous intéressons à un type de démontage ne nécessitant pas de report sur un substrat cible. Le but ici est de séparer, sans report la couche 14 après réalisation des circuits ou composants C, dans le cas où cette couche 14 est suffisamment épaisse pour être autoportée mais trop fine pour subir sans dommage un procédé de réalisation de circuits (typiquement en dessous de quelques centaines de µms, voire de l'ordre de quelques dizaines de µms). Le procédé de réalisation du substrat démontable reste identique à l'un de ceux décrits précédemment pour mener à la structure de la figure 4 par exemple. Si l'on s'intéresse au silicium en diamètre 200mm, l'épaisseur standard de substrats est de 725µm. Si l'application requiert un substrat final de 80µm par exemple, on choisira pour le substrat support 11 un substrat de silicium d'épaisseur de 725 - 80 = 645 µm. Ce substrat de 645 µm est ensuite collé par adhésion moléculaire, par exemple, à une plaque de 725 µm en ménageant des zones de plus faible tenue mécanique. La plaque de 725 µm est alors amincie, par exemple par rectification et polissage mécano-chimique jusqu'à atteindre les 80 µm désirés. L'ensemble après assemblage correspond donc aux standards et résiste de manière suffisante aux procédés de fabrication de tout ou partie des composants. Après la réalisation de ces derniers, l'une des techniques de démontage cités auparavant peut être utilisée (figure 31 ; attaque HF et contraintes mécaniques) à la différence que le substrat 16 peut être omis. Dans certains cas néanmoins, sa présence peut être intéressante. Après démontage, la seule couche 14 autoportée représente le substrat final d'intérêt caractérisé par un substrat d'épaisseur de 80µm comprenant les composants. Le reste du substrat peut être recyclé.

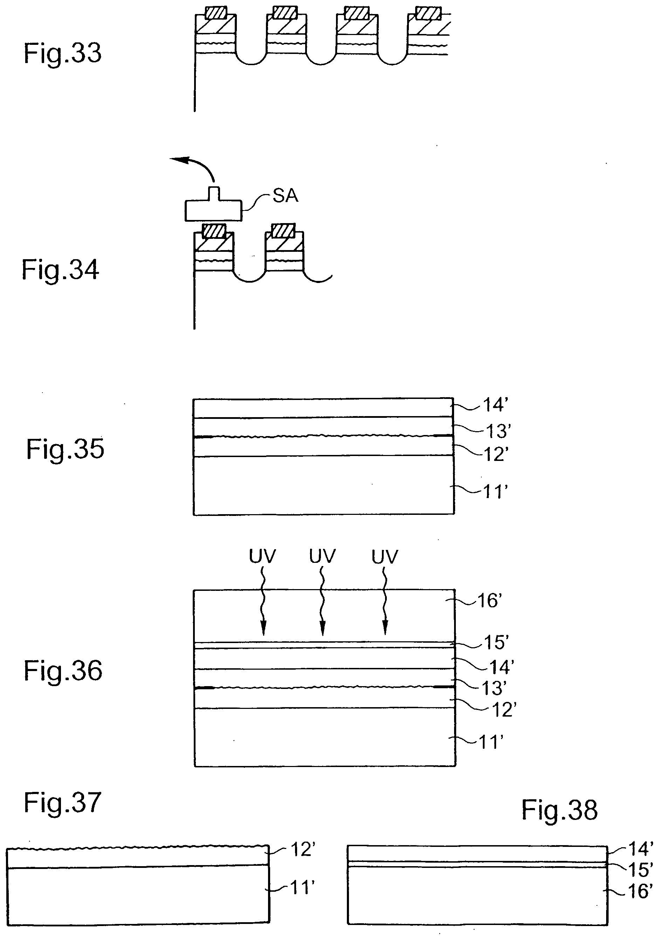

Il peut y avoir, si on le souhaite, une découpe des puces avant démontage, ainsi que cela ressort des figures 33 et 34 : sur la figure 33 apparaissent des entailles entre les composants, s'étendant jusqu'en-dessous de la future zone de démontage, et la figure 34 représente un support d'arrachement SA collé sur l'une des parcelles et destiné à permettre l'arrachement après éventuelle attaque HF.

Suivant les opérations technologiques qui doivent être réalisées sur le substrat démontable avant la séparation, notamment les traitements thermiques, chimique et selon la nature des contraintes mécaniques, les paramètres de fragilisation devront être adaptées. Par exemple, si le substrat démontable consiste en une couche de surface en germanium possédant une interface de collage SiO2-SiO2 devant subir une température d'épitaxie de 550°C (cas typique dans le cas de la croissance de GaInAs constituant une cellule solaire pour le spatial), alors la rugosité devra être de avantageusement de 0,4 nm rms pour que le substrat soit démontable.

Un autre exemple de mise en oeuvre concerne la réalisation de circuits pour cartes à puces pour lesquels la souplesse du support devient critique, d'une part du fait de l'augmentation de la taille des circuits, et d'autre part car la tendance est à vouloir des cartes de plus en plus résistantes aux déformations. Un support de silicium monocristallin dont l'épaisseur est supérieure à la cinquantaine de µms est dans ce cadre trop cassant du fait de sa trop grande épaisseur lorsqu'il est soumis à une effort de flexion tel que peut en subir régulièrement une carte à puces.

La figure 35 représente un ensemble de départ similaire à celui de la figure 4, avec un substrat de départ 11', recouvert d'une couche d'oxyde de silicium 12', elle-même collée par adhésion moléculaire à une seconde couche d'oxyde de silicium 13', elle-même recouverte d'une couche 14' en silicium. Les circuits sont réalisés au sein de la couche 14' de silicium. Puis, pour l'assemblage sur le deuxième support 16' -figure 36-, on choisit de préférence une colle qui permet d'obtenir une couche 15 très fine, tout en ayant une tenue mécanique la plus forte possible à basse température, par exemple <400°C, pour ne pas risquer de détériorer les composants de la couche active réalisés avant cette étape de collage. Il peut avantageusement s'agir de colles thermodurcissables voire de colles durcissables par application de rayons UV (il suffit dans ce cas de choisir un substrat final 16' qui est transparent aux UV).

Pour découper selon la zone fragilisée du substrat démontable (ici l'interface de collage 12'/13'), il peut paraître délicat de réaliser un décollement purement chimique de type « lift-off » car les colles adhésives, ainsi que les substrats transparents aux UV (de quartz et de verre, en pratique) ne sont pas totalement inertes aux produits chimiques (HF, solvants,...). Par contre, pour décoller la structure au niveau de l'interface fragile 12'/13', une action purement mécanique peut être suffisante si l'énergie de collage au niveau de la couronne est inférieure à la tenue de la colle adhésive et des différentes couches composant les circuits intégrés (cela peut être assez facilement obtenu). Il est alors possible de réutiliser le substrat du substrat démontable plusieurs fois. Outre une attaque chimique limitée de la couronne, il est possible d'autre part d'éliminer celle-ci en réalisant une découpe circulaire de la structure après le collage adhésif. Cette découpe peut être avantageusement réalisée par laser à la frontière entre la zone à forte énergie de collage et à plus faible énergie de collage. Si la couronne ne fait que quelques mm de largeur voir moins, il est alors possible de réutiliser le substrat.

De façon générale, on obtient le résidu du premier substrat, support du substrat jusqu'ici dénommé "démontable" (voir la figure 37) réutilisable après, de préférence, polissage de la couche 12' ainsi que la couche active 14' (figure 38) reportée sur cet autre support 16', ou en variante libre et autoportée si l'épaisseur de la couche 14' le permet.

A la différence des exemples précédents, le second substrat 16' peut en variante n'être qu'un substrat intermédiaire dans un procédé bien plus long qui se poursuivra ou par la suppression pure et simple de ce substrat intermédiaire 16' ou par un autre report de couche sur encore un autre support, en général avec suppression du substrat 16'. Le substrat démontable obtenu à l'aide de la technique décrite auparavant est collé, après avoir été « processé », sur le substrat intermédiaire. Ce substrat intermédiaire peut être un substrat rigide ou souple (voir les exemples précédents). S'il est rigide ce peut même être une plaque de silicium.

Pour le collage adhésif, on peut aussi envisager l'utilisation de films adhésifs connues de l'homme de l'art notamment pour procéder aux opérations de découpe de plaquettes de silicium et d'encapsulation de circuits intégrés ou encore de "packaging" ou encore de "back-end" selon deux expressions anglo-saxonne (« sticky bleu », films adhésif en Teflon®, ..). Si ce film adhésif est double face, il peut être judicieux de coller en face arrière de ce film, en tant que substrat intermédiaire, un substrat ou support permettant la rigidification de l'ensemble au moment de la découpe.

Les techniques de décollement envisageables incluent l'application de forces de traction et/ou de cisaillement et/ou de flexion. A ces applications de forces, il peut être judicieux de coupler une attaque chimique de l'interface voire d'autres moyens tels que ultrasons. Dans le cas où l'interface à décoller est du type oxyde, l'attaque de l'interface à énergie faible facilite le filage de l'interface de collage et donc le transfert de la couche processée sur le substrat intermédiaire. Dans ces conditions, il est avantageux que les couches processées soient protégées (par exemple par un dépôt supplémentaire de nitrure dans le cas d'une attaque HF) .

Les moyens d'application des contraintes peuvent être appliqués directement sur le film mince ou encore sur le substrat intermédiaire (poignée). Ils peuvent être mécaniques (par insertion d'une lame au niveau de l'interface de collage, notamment) et/ou par l'utilisation d'une pince de décollement (WO 00/26000) et/ou par jet, par l'insertion d'un flux gazeux comme cela est décrit dans le document FR 2796491 et/ou d'un liquide (EP 0925888, EP 0989593). Dans le cas du flux gazeux (ou même d'un liquide, avec par exemple du HF si l'interface est de l'oxyde), le substrat démontable peut avantageusement être préalablement préparé (par gravure chimique par exemple) pour pouvoir amener le fluide localement au niveau de l'interface de collage. Cette condition permet de faciliter le décollement préférentiellement au niveau de l'interface de collage des structures multicouches, où doit se faire le décollement, en protégeant les différentes couches de la structure comportant les composants. Ainsi, il est possible de décoller l'interface de collage même lorsque l'adhérence entre elles des couches internes des composants est faible. On peut se référer ici aux figures 39 et 40.

Le substrat intermédiaire, parfois appelé « poignée » peut ensuite être découpé (ou non), totalement ou en partie (entailles ou débuts de découpe) en éléments correspondant aux composants électroniques et qui peuvent être reportés sur différents supports. Ce report peut être un report collectif où l'ensemble des composants, même s'ils ne sont reliés entre que par un support, sont transférés en même temps lors de la même opération technologique ou être un report composant à composant (ou puce à puce) s'ils font l'objet les uns après les autres de ce report. Ces supports peuvent être en plastique comme sur une carte à puce et, dans ce cas on utilise avantageusement de la colle pour le report. Les éléments peuvent aussi être reportés sur une plaque comportant d'autres dispositifs électroniques ou optoélectroniques et, dans ce cas, le report peut mettre à nouveau en oeuvre une technique d'adhésion moléculaire (voir les figures 4 et 19 à 22 en imaginant la présence supplémentaire de composants réalisés dans la couche 14). Les éléments peuvent être reportés par des moyens classiques tels ceux dénommés « pick and place ». Les éléments peuvent être également reportés sur un autre support pour améliorer les propriétés par exemple d'un point de vue thermique.

Ensuite, en exerçant une contrainte ou en chauffant localement (à l'aide d'un laser par exemple), la couche mince, préalablement collée sur son support définitif, peut être séparée (élément par élément, ou globalement) de sa poignée par l'intermédiaire de forces mécaniques.

Comme indiqué à propos des figures 17 et 18, les zones Z1 et Z2 peuvent ne pas décrire un système composé d'une zone circulaire centrale Z1 entourée d'une couronne externe Z2. Une multitude d'autres structures peut être envisagée. Le réseau de carrés de la figure 18 peut être remplacé par d'autres formes de réseaux (lignes, colonnes, cercles concentriques, etc..) dont le pas et autres dimensions géométriques peuvent être variable en fonction de l'application et de la technique démontage retenue. L'intérêt d'adopter un réseau peut s'avérer préférable lorsque la structure qui sera réalisée imposera des contraintes mécaniques importantes qui se reporteront au niveau de l'interface de liaison (dans ce cas une répétition à courte échelle de zones à bonne tenue mécanique est préférable), ou lorsque la couche 14 peut présenter des trous, volontaires ou non, mettant à découvert localement la zone de liaison qui à son tour peut faire l'objet de délamination intempestive dont l'épicentre est le trou, ou encore par intérêt de simplification de procédé (par exemple pour une découpe en puces unitaires) dans le cas de la réalisation de puces. Dans le principe, des dimensions de l'ordre du µm seront préférées pour les structures ayant à subir un niveau de contraintes élevées (cas par exemple d'une hétéro-épitaxie ou tout autre dépôt ou étape technologique mettant la structure en tension ou compression marquée) ou dans le cas de petits circuits, ou encore de circuits réalisés avec une résolution photolithographique sub-micronique. Dans le cas contraire des échelles de l'ordre du mm voire du cm sont préférables. Plus de deux zones peuvent bien sûr être envisagées (Z1 ; Z2, Z3 etc...) selon de nombreuses combinaisons. Au delà d'un nombre discret de types de zones à tenue mécanique déterminée, on peut également envisager un continuum de zones caractérisé par une variation continue de la tenue mécanique. Ainsi on peut envisager par exemple que la tenue mécanique passe continûment d'une valeur maximum au voisinage du bord vers une valeur minimale en son centre. Cette variation peut présenter ou non une symétrie de révolution autour de l'axe perpendiculaire au plan du substrat. Les procédés de réalisation pour aboutir à ce type de substrat et à leur utilisation lors du démontage restent en tout point similaire aux descriptions données dans le cas de la figure 1 à 8, dès lors que les formes géométriques mises en oeuvre sont adaptées (formes des masques pour formation des couches de protection pour rugosification sélective, formes des masques pour dépôts sélectifs , forme des tissus de polissage qui peuvent être conçus pour polir préférentiellement des anneaux concentriques, etc ...).

Ces formes géométriques restent compatibles avec le transfert d'une couche 14 dans sa globalité du substrat initial démontable 11+12+13+14 vers le substrat cible 16.

Par opposition aux modes de mise en oeuvre du procédé selon l'invention qui tendent à favoriser un décollement de la couche de son substrat au niveau global, c'est à dire à l'échelle de la totalité du substrat, d'autres tendent à délimiter des parcelles, dont la forme est clairement liée aux puces ou composants qui seront réalisés à partir de la couche active. La figure 41 en représente un exemple, avec un grossissement au niveau de la zone qui accueillera ultérieurement la puce (ou tout autre composant). Cette structure peut être répétée autant de fois qu'il y a de composants à démonter sur le substrat initial. Idéalement, chaque zone Z2 entoure ou simplement longe le contour de chaque parcelle de zone Z1. La surface du composant (ou puce etc...) peut correspondre exactement avec la zone Z1 ou au contraire être supérieure ou bien encore inférieure, dans des configurations où l'une des la surfaces du composant et de celle de la zone Z1 englobe l'autre. La configuration retenue dépend de la technique qui sera utilisée lors du démontage. Ces techniques peuvent être les mêmes, que celles qui ont été décrites auparavant pour le démontage d'un substrat ne présentant qu'une couronne Z2 entourant un disque central Z1. Une variante intéressante consiste à utiliser une des techniques classiques de découpe de composant (sciage, découpe laser,..) pour venir découper ou délimiter des tranchées, au moins partiellement autour des puces, parcelles etc... Une autre variante intéressante repose sur l'utilisation de gravures chimiques associées à une opération de phot-lithographie, pour réaliser des tranchées identiques et/ou provoquer l'enlèvement de la zone de liaison correspondant à Z2. Comme le montre la figure 41 dans un exemple particulier, les traits verticaux en pointillés visualisent le contour des parcelles voulues. A titre d'exemple, après avoir préparé le collage par adhésion moléculaire sur une grande étendue, on ne découpe que les couches 3 et 4 suivant le contour représenté, puis on décolle chaque parcelle vis-à-vis du substrat, ce qui revient à considérer que l'on décolle le substrat vis-à-vis de chaque parcelle (en variante, on peut découper toutes les couches, soit l'ensemble des parcelles à la fois). Dans la mesure où, après découpe, la zone à tenue mécanique élevée est en périphérie, le risque de délamination au cours d'étapes de traitement, par exemple destinées à réaliser sur la couche 3 ou 4 des éléments électroniques, optiques ou autres, est réduit, tandis que, lorsque le décollement est voulu, il se propage sans difficulté, de manière contrôlée, dans la zone centrale (il peut avoir été amorcé en périphérie).

La combinaison de distribution de zones Z1 et Z2 visant à former une couronne extérieure au niveau du substrat, tel que le montre la figure 4, avec une distribution visant à protéger chacune des puces, tel que le montre la figure 13, est une des combinaisons intéressantes.

Les exemples de mise en oeuvre décrits précédemment ne se limitent bien entendu pas au simple cas du silicium monocristallin mais peuvent d'étendre à de nombreux matériaux tels que d'autres matériaux semi-conducteurs (Ge, SiGe, SiC, GaN et autres nitrures équivalents, AsGa,InP,..) ou en matériaux ferroélectriques ou piézo-électriques (LiNbO3, LiTaO3) ou magnétiques « processés », qu'ils fassent l'objet de réalisation de composants ou non avant le démontage.

Il a déjà cité que pour le cas correspondant à un substrat démontable consistant en une couche de surface en germanium possédant une interface de collage SiO2-SiO2 devant subir une température d'épitaxie de 550°C (cas typique dans le cas de la croissance de GaInAs constituant une cellule solaire pour le spatial), alors la rugosité devra être de avantageusement de 0,4 nm rms pour que le substrat soit démontable.

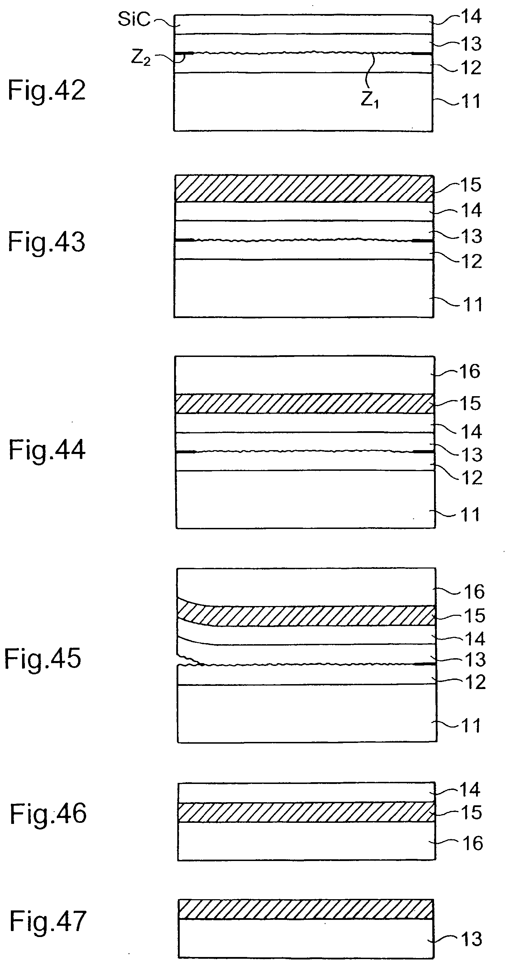

Un autre exemple est celui où l'on souhaite réaliser une étape d'épitaxie d'un empilement épitaxial sur un substrat démontable. Ceci est notamment le cas pour la réalisation de LEDs bleues et blanches ou de diodes laser en couches fines (par exemple pour une meilleure extraction de la lumière émise ou pour une meilleure évacuation de la chaleur grâce à un report sur un substrat bon conducteur thermique tel que le cuivre ou diamant). Dans ce cas, l'empilement épitaxial considéré est à base de semi-conducteurs composés dérivés du GaN (AIN, GaAIN, GaAlInN,..). Un procédé consiste à former selon une des méthodes décrites auparavant, ne structure démontable équivalente à celle de la figure 4 (ou de la figure 26 ou encore 35) où la couche 14 est du SiC 6H (face Si reporté vers le haut selon les figures), les couches 12 et 13 sont, pour l'exemple de la figure 4, des oxydes de Silicium et le substrat 11 est en SiC polycrisytallin (ou saphir). Sur cette structure (figure 42) on procède à la formation par épitaxie de l'empilement 15 à base de nitrures (figure 43). Cette épitaxie peut être réalisée par des techniques d'épitaxie bien connues de l'homme du métier sous les acronymes anglo-saxon de MBE (pour Molecular Beam Epitaxy) pour une catégorie d'entre elles ou par MOCVD (Metallo-Organic Chemical Vapor Deposition) pour une autre. Dans le premier cas, les températures de croissance épitaxiale dépassent rarement 600°C tandis que les températures typiques pour la seconde sont de l'ordre de 1050-1100°C. Pour chacune de ces deux techniques, le choix des couples ou ensemble de zones à tenue mécanique Z1, Z2 etc... doit être optimisé. Dans le second cas, on choisira par exemple un des procédés décrits précédemment basé sur une rugosification des deux couches d'oxyde 12 et 13 par attaque HF, On choisira également une variante consistant à former une couronne de 5mm de large à partir du bord du substrat. Cette structure fait ensuite l'objet de la croissance épitaxiale MOCVD pour réaliser à 1100°C un empilement dont l'épaisseur est de l'ordre de 1µm. Optionnellement, la structure est recuite avant épitaxie, typiquement dans la gamme de 900 à 1200°C afin de consolider fortement la tenue mécanique de la couronne. Après croissance, l'ensemble fait l'objet d'un dépôt d'oxyde, d'une planarisation par CMP, d'un collage par adhésion moléculaire (par exemple sur un substrat silicium) et d'un recuit à 1100°C pour renforcer ce dernier collage. On réalise la couche 16 (figure 44). Enfin on procède à la séparation selon l'interface de collage (figure 45). Quelques heures en bain de HF à 50% suffisent à graver latéralement la couche d'oxyde sur les quelques mms où cette interface correspond à la zone Z2 mettant ainsi à découvert la zone Z1. Ensuite, une séparation par efforts mécaniques est réalisée, par exemple par insertion d'une lame, par application d'un jet d'eau sous pression ou d'air comprimé selon par exemple les techniques décrits précédemment. Une désoxydation finale permet enfin d'enlever le résidu de la couche 13 d'oxyde -figure 46-. Optionnellement, au moins la couche 14 de SiC ayant servi de couche de nucléation à l'empilement épitaxial peut être supprimée par gravure (figure 47 ). La réalisation de diodes peut voir lieu avant ou après le transfert final.

### 2 - couche enterrée fragile comportant des micro-cavités, des micro-bulles ou des "platelets" (hors invention)

L'interface entre le substrat et ce qui est destiné à former la couche « active » peut en variante être formé par une couche enterrée fragile, formée par exemple de micro-cavités, de micro-bulles ou de « platelets », Ce procédé est utilisable avec de nombreux matériaux semi-conducteur ou pas.

La distinction entre les zones de tenue mécanique différentes est obtenue par des niveaux différents de fragilisation ; il suffit pour ce faire, dans le cas où, comme aux figures 1 à 3, on veut obtenir une zone centrale entourée d'une zone périphérique ayant une meilleure tenue mécanique, de moins fragiliser en périphérie qu'au centre, par exemple, en introduisant en périphérie moins d'espèces susceptibles de fragiliser la zone (par exemple par une implantation d'hydrogène) : cela peut, par exemple, être obtenu en masquant une partie de la couche pendant une partie de l'opération d'implantation, ou en modifiant le balayage en cours d'implantation ; cela peut encore être obtenu en réalisant des implantations successives, dans des conditions différentes, sur les diverses zones dont on veut différencier les propriétés. On peut également fragiliser des zones de façon différente en leur appliquant des traitements thermiques différents et appropriés afin d'obtenir différents niveaux de fragilisation.

Concernant la répartition des zones Z1 et Z2 (une couronne unique, définition de parcelles, réseaux de zones, multitude de zones,...), les techniques de démontage de ces structures (par contraintes mécaniques, traitements chimiques, traitements thermiques, enlèvement sélectifs des couronnes et zones Z2,... ) et leur exemple de mise en ouvre, les éléments et exemples donnés en section 1 concernant le cas d'un interface ou couche intermédiaire réalisée par adhésion moléculaire restent valables.

### 3 - interface formée d'une couche poreuse (hors invention)

Comme on le sait, notamment du document EP0843346 A2, une couche poreuse peut être obtenue, en particulier parmi les matériaux suivants : Si, GaAs, InP, GaAsP, GaAlAs, InAs, AlGaSb, ZnS, CdTe and SiGe, sous des formes qui peuvent être monocristallines, polycristallines ou amorphes.

Ce n'est donc qu'à titre d'exemple que la suite décrit le cas du silicium.

Il est possible d'obtenir par électrolyse dans du HF du silicium poreux. On sait faire varier la porosité du Si en modifiant la concentration du HF ou en faisant varier le courant. Par exemple, la porosité varie de 2,1 g/cm³ à 0,6 g/cm³ en diminuant la concentration de HF de 50% à 20%.

Ainsi, en protégeant la couronne extérieure de la plaquette de Si par un dépôt épais (par exemple en nitrure, oxyde, ou silicium polycristallin) il est possible de rendre poreux une zone centrale de la couche de silicium tout en en conservant la périphérie intacte. Ensuite, il suffit d'éliminer la couche déposée à la périphérie, et d'électrolyser la plaquette entière. En conséquence de ces deux électrolyses on obtient une porosité supérieure au centre de la plaque par rapport à la périphérie.

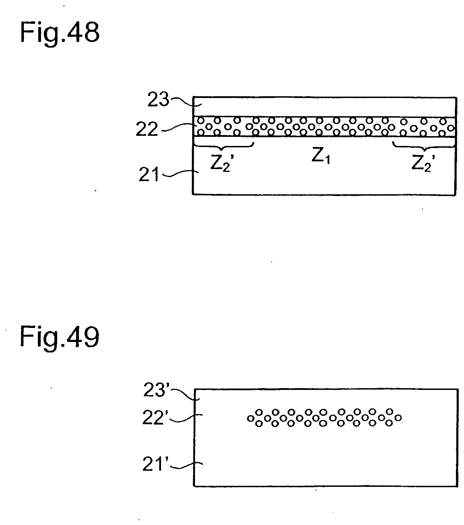

Ensuite, une épitaxie permet de créer une couche monocristalline de Si sur cette couche poreuse (voir la figure 48, qui représente un ensemble comportant un substrat 21, la couche poreuse 22 présentant des différences contrôlées de porosité entre les diverses zones Z1' et Z2', et une couche mince 23). Des recuits lissants de type recuit hydrogène sont avantageusement utilisés avant l'étape d'épitaxie afin de reboucher au moins en partie la surface des pores.

Il peut y avoir une continuité cristallographique entre les diverses couches dans la mesure où elles ont le même constituant.

L'épaisseur de cette couche monocristalline, qui devient ainsi la couche active, dépend des applications visées.

Suivant l'épaisseur de cette couche active, elle peut devenir après démontage une couche autoportée (si elle est assez épaisse) ou rapportée sur un substrat cible (par adhésion moléculaire par exemple) (surtout pour des épaisseurs faibles). Le décollement de la couche active de son substrat peut se faire chimiquement ou par l'introduction d'un fluide, localement au niveau de la couche poreuse.

Une variante peut consister à ne pas rendre poreuse la périphérie sur quelques mm (cas de la figure 49, avec un substrat 21', une couche 22' dont certaines zones sont poreuses, et une couche monocristalline 23'). Il devient alors judicieux d'éliminer cette couronne en réalisant une découpe (mécanique ou par laser ou chimiquement par HF/HNO₃ ou TMAH).

Concernant la répartition des zones Z1 et Z2 (une couronne unique, définition de parcelles, réseaux de zones, multitude de zones,...), les techniques de démontage de ces structures (par contraintes mécaniques, traitements chimiques, traitements thermiques, enlèvement sélectifs des couronnes et zones Z2,... ) et leur exemple de mise en ouvre, les éléments et exemples donnés en section 1 concernant le cas d'un interface ou couche intermédiaire réalisée par adhésion moléculaire restent valables.

De manière générale, on peut noter que :
- l'interface peut être une simple surface de contact ou une couche de liaison,
- les parcelles peuvent être distribuées selon un réseau de carrés, de lignes, de cercles concentriques, etc...,
- la définition géométrique des parcelles est de préférence liée à l'emplacement et à la taille des puces (à la zone Z2 près ou au trait de scie près...,
- l'étape de préparation de la surface avant collage peut comporter une rugosification de la couche oxyde,
- la préparation avant collage peut influer sur la rugosité mais aussi sur l'effet hydrophile,
- pour obtenir une rugosité plus importante de la première zone par rapport à celle de la seconde zone, on peut rugosifier l'ensemble des deux zones et réduire la rugosité de la seule seconde zone,
- la différence Z1, Z2 peut provenir d'un traitement thermique post-collage moléculaire localisé ; en alternative, on peut utiliser des recuits thermiques localisés (faisceau laser, fours non-uniformes, chauffage par lampe, etc...) après l'opération de collage,
- lorsque l'interface est une couche enterrée fragilisée par implantation d'un élément gazeux, ce dernier est de préférence maintenu gazeux,
- pour obtenir le décollement, on peut avantageusement éliminer des portions de matière correspondant à la zone Z2, par gravure chimique et/ou par enlèvement mécanique de matière (usinage),
- l'étape de décollement peut se faire par attaque acide et/ou application de contraintes ; il peut y avoir mise en oeuvre d'un jet, d'eau, d'air ou de fluide pressurisé,
- la description qui précède a insisté sur le cas d'une couche en silicium, mais il peut aussi s'agir de SiC, de GaN, de GaAs, de InP, de SiGe ou de semi-conducteurs dérivés,
- il peut y avoir une étape d'épitaxie sur la couche avant démontage ; il peut de même y avoir réalisation totale ou partielle de composant avant démontage,
- il peut y avoir des zones Z3, voire Z4... ayant des niveaux de tenue mécaniques différents de ceux des zones Z1 et Z2,
- il peut y avoir une évolution continue de la tenue mécanique entre des extrêmes, et non pas des paliers reliés par des sauts discrets,
- la différence de tenue mécanique entre les zones peut provenir d'une différence de composition (interface formée d'une couche dont des zones sont en un matériau et l'autre en un autre matériau ; ou interface formée en partie par le matériau du substrat ou de la couche, et en partie par une couche rapportée).

## Revendications

1. Procédé de préparation d'une couche mince comportant :
- une étape de réalisation d'une interface démontable entre une couche destinée à faire partie de cette couche mince et un substrat, cette interface étant réalisée de sorte qu'au moins une première zone (Z1, Z1') a un premier niveau de tenue mécanique non nul, et une seconde zone (Z2, Z2') a un second niveau de tenue mécanique sensiblement supérieur au premier niveau de tenue mécanique,
- une étape ultérieure de démontage ayant lieu dans les première et seconde zones, et
- entre l'étape de réalisation de l'interface et l'étape de démontage, une étape de fabrication dans la couche de tout ou partie de composants microélectroniques, optiques ou mécaniques,
**caractérisé en ce que** :
a) lors de l'étape de fabrication, la première zone est entourée par la seconde, et
b) lors de l'étape de démontage, le démontage est amorcé dans la seconde zone, et
c) lors de l'étape de réalisation d'une interface démontable, l'interface est réalisée par collage.

2. Procédé selon la revendication 1, **caractérisé en ce que** l'interface est réalisé entre une surface du substrat et une surface de la couche, et l'étape de réalisation de l'interface comporte une étape de préparation d'au moins l'une de ces surfaces, une étape de collage selon laquelle cette surface qui a été préparée est collée à l'autre surface par collage par adhésion moléculaire.

3. Procédé selon la revendication 2, **caractérisé en ce que** l'étape de préparation de surface comporte une étape selon laquelle la surface est entièrement rendue rugueuse et une étape selon laquelle la rugosité de certaines parties est améliorée pour permettre d'obtenir des forces de collage plus grandes.

4. Procédé selon la revendication 3, **caractérisé en ce que** la rugosité de certaines parties est diminuée par polissage chimique, par traitement mécanique ou mécano-chimique ou par gravure sèche.

5. Procédé selon l'une quelconque des revendications précédentes, **caractérisé en ce que** chacun des composants est réalisé en regard de la première zone de faible tenue mécanique entourée de la seconde zone à plus forte tenue mécanique.

6. Procédé selon l'une quelconque des revendications précédentes, **caractérisé en ce que** l'étape de démontage comporte :
- l'élimination, par des techniques de gravure chimique ou des techniques mécaniques, de la seconde zone jusqu'à mettre à découvert la première zone, et ensuite
- la séparation, au niveau de la première zone, de la couche, destinée à faire partie de la couche mince, et du substrat.

7. Procédé selon la revendication 6, dans lequel la séparation au niveau de la première zone est réalisée par application de contraintes mécaniques.

8. Procédé selon l'une quelconque des revendications précédentes, dans lequel la seconde zone constitue la périphérie d'une plaque dont la première zone constitue le coeur.

9. Procédé selon l'une quelconque des revendications 1 à 7, dans lequel la première zone est parcellaire, chaque parcelle étant entourée d'une seconde zone.

10. Procédé selon la revendication 9, dans lequel, après l'étape de réalisation de l'interface sont effectués une étape de découpe d'au moins une parcelle dans cette couche contenant une partie de la première zone et une partie de la seconde zone de telle sorte que cette partie de la seconde zone longe la périphérie de cette parcelle, puis ladite étape de démontage.

## Patentansprüche

1. Verfahren zur Herstellung einer dünnen Schicht, umfassend:
- einen Schritt der Realisierung einer abspaltbaren Grenzfläche zwischen einer Schicht, die dazu bestimmt ist, Teil dieser dünnen Schicht zu sein, und einem Substrat, wobei diese Grenzfläche so realisiert wird, dass mindestens eine erste Zone (Z1, Z1') einen mechanischen Festigkeitswert ungleich null aufweist und eine zweite Zone (Z2, Z2') einen zweiten mechanischen Festigkeitswert aufweist, der deutlich über dem ersten mechanischen Festigkeitswert liegt,
- einen späteren Schritt der Abspaltung, der in der ersten und zweiten Zone stattfindet,
- zwischen dem Schritt der Realisierung der Grenzfläche und dem Schritt der Abspaltung einen Schritt der Herstellung aller oder eines Teils der mikroelektronischen, optischen oder mechanischen Komponenten in der Schicht,
**dadurch gekennzeichnet, dass**:
a) beim Schritt der Herstellung die erste Zone von der zweiten umgeben wird und
b) beim Schritt der Abspaltung die Abspaltung in der zweiten Zone eingeleitet wird und
c) beim Schritt der Realisierung einer abspaltbaren Grenzfläche die Grenzfläche durch Kleben realisiert wird.

2. Verfahren nach Anspruch 1, **dadurch gekennzeichnet, dass** die Grenzfläche zwischen einer Oberfläche des Substrates und einer Oberfläche der Schicht realisiert wird und der Schritt der Realisierung der Grenzfläche einen Schritt der Vorbereitung mindestens einer dieser Oberflächen, einen Schritt des Klebens, bei dem diese vorbereitete Oberfläche durch Kleben mit molekularer Haftung an die andere Oberfläche geklebt wird, umfasst.

3. Verfahren nach Anspruch 2, **dadurch gekennzeichnet, dass** der Schritt der Herstellung der Oberfläche einen Schritt, bei dem die Oberfläche vollkommen aufgeraut wird, und einen Schritt, bei dem die Rauheit bestimmter Teile verbessert wird, umfasst, um einen Erhalt größerer Klebkräfte zu ermöglichen.

4. Verfahren nach Anspruch 3, **dadurch gekennzeichnet, dass** die Rauheit bestimmter Teile durch chemisches Polieren, mechanische oder mechanischchemische Behandlung oder Trockenätzen verringert wird.

5. Verfahren nach einem der vorhergehenden Ansprüche, **dadurch gekennzeichnet, dass** jede der Komponenten in der erste Zone mit geringer mechanischer Festigkeit, die von der zweiten Zone mit höherer mechanischer Festigkeit umgeben ist, realisiert wird.

6. Verfahren nach einem der vorhergehenden Ansprüche, **dadurch gekennzeichnet, dass** der Schritt der Abspaltung umfasst:
- Eliminierung der zweiten Zone durch chemische Ätztechniken oder mechanische Techniken bis zum Freilegen der ersten Zone und anschließend
- Trennung der Schicht, die dazu bestimmt ist, Teil der dünnen Schicht zu sein, an der ersten Zone vom Substrat.

7. Verfahren nach Anspruch 6, bei dem die Trennung an der ersten Zone durch Anwendung mechanischer Beanspruchungen realisiert wird.

8. Verfahren nach einem der vorhergehenden Ansprüche, bei dem die zweite Zone den Umfang einer Platte bildet, deren erste Zone das Herzstück bildet.

9. Verfahren nach einem Ansprüche 1 bis 7, bei dem die erste Zone parzellig vorliegt, wobei jede Parzelle von einer zweiten Zone umgeben ist.

10. Verfahren nach Anspruch 9, bei dem nach dem Schritt der Realisierung der Grenzfläche ein Schritt des Schneidens mindestens einer Parzelle in dieser Schicht, die einen Teil der ersten Zone und einen Teil der zweiten Zone derart enthält, dass dieser Teil der zweiten Zone entlang des Umfangs dieser Parzelle verläuft, und dann der Schritt der Abspaltung erfolgt.

## Claims

1. Method of preparing a thin layer including:
- a step of producing a detachable interface between a layer intended to form part of said thin layer and a substrate, said interface being produced that at least a first region (Z₁, Z₁') has a non-zero first level of mechanical strength and a second region (Z₂, Z₂') has a second level of mechanical strength significantly greater than the first level of mechanical strength,
- a subsequent step of detaching taking place in the first and second regions, and
- between the step of producing the interface and the detaching step, a step of producing in the layer all or part of microelectronic, optical or mechanical components,
**characterized in that**:
a) in the producing step, the first region is surrounded by the second, and
b) in the detaching step, the detachment is initiated in the second region, and
c) in the step of producing a detachable interface, the interface is produced by bonding.

2. Method according to Claim 1, **characterized in that** the interface is produced between a surface of the substrate and a surface of the layer and the step of producing the interface includes a step of preparing at least one of said surfaces and a bonding step during which said surface, which has been prepared, is bonded to the other surface by molecular adhesion bonding.

3. Method according to Claim 2, **characterized in that** the surface preparation step includes a step in which the surface is roughened entirely and a step in which the roughness of some portions is enhanced to obtain greater bonding forces.

4. Method according to Claim 3, **characterized in that** the roughness of some portions is reduced by chemical polishing, mechanical treatment or chemical-mechanical treatment, or dry etching.

5. Method according to any one of the preceding claims, **characterized in that** each component is produced facing the first region of low mechanical strength surrounded by the second region of higher mechanical strength.

6. Method according to any one of the preceding claims, **characterized in that** the detaching step includes:
- eliminating, by chemical etching techniques or mechanical techniques, the second region until the first region is uncovered, and then
- separating, at the level of the first region, the substrate and the layer that is intended to form part of the thin layer.

7. Method according to Claim 6, in which the separation at the level of the first region is achieved by applying mechanical stresses.

8. Method according to any one of the preceding claims, in which the second region constitutes the periphery of a wafer of which the first region constitutes the core.

9. Method according to any one of Claims 1 to 7, in which the first region is divided into fragments, each fragment being surrounded by a second region.

10. Method according to Claim 9, in which, after the step of producing the interface, there follows a step of cutting at least one fragment into said layer containing a portion of the first region and a portion of the second region so that said portion of the second region extends along the periphery of said fragment, then said detaching step.
